# EUROPEAN PATENT APPLICATION

(11) **EP 4 645 383 A1**
(43) Date of publication of application: **05.11.2025**
(21) Application number: 24208582.7
(22) Date of filing: 24.10.2024
(51) Int. Cl.: H01L 23/31, H01L 23/62

(54) **SEMICONDUCTOR DEVICE WITH EDGE TERMINATION REGION**

(30) Priority: 30.04.2024 KR 20240057515
(71) Applicant: Samsung Electronics Co., Ltd., Suwon-si, Gyeonggi-do 16677 (KR)
(72) Inventor: KO, Mingu, Suwon-si (KR); KIM, Youngcheol, Suwon-si (KR); KIM, Jaeyoung, Suwon-si (KR); KIM, Jongseob, Suwon-si (KR); KIM, Taehun, Suwon-si (KR); PARK, Gyeong-Seon, Suwon-si (KR); HONG, JeongPyo, Suwon-si (KR)
(74) Representative: Marks & Clerk LLP

(57) **Abstract**

A semiconductor device according to various example embodiments includes a substrate including a cell region and a peripheral circuit region outside the cell region, a first conductivity type semiconductor layer on a first surface of the substrate, a second conductivity type doping well region within the first conductivity type semiconductor layer, a gate electrode above the first conductivity type semiconductor layer in the cell region, a gate insulating layer between the first conductivity type semiconductor layer and the gate electrode, a source electrode above the second conductivity type doping well region, a drain electrode on a second surface of the substrate, the second surface being opposite the first surface, a barrier pattern including a first barrier layer above the first conductivity type semiconductor layer, and a second barrier layer on the first barrier layer in the peripheral circuit region.

## Description

### BACKGROUND

Various example embodiments relate to a semiconductor device.

In modern society, a semiconductor device is closely related to daily life. In particular, an importance of an electric power semiconductor device used in various fields such as a transportation field (e.g., an electric vehicle, a railway vehicle, an electric tram, or the like), a renewable energy system (e.g., a solar power generation system, a wind power generation system, or the like), and a mobile device is gradually increasing. The electric power semiconductor device is a semiconductor device used to handle a high voltage or a high current, and performs a function such as electric power conversion, control, or the like in a large electric power system or a high-power electronic device. The electric power semiconductor device may have an ability to handle high electric power and may have high durability, so that it may handle large amounts of current and withstand high voltages. For example, the electric power semiconductor device may handle a voltage with hundreds to thousands of volts and a current with tens of amperes to thousands of amperes. The electric power semiconductor device may improve an efficiency of electrical energy by minimizing electric power loss. Additionally, the electric power semiconductor device may be stably driven even in an environment such as a high-temperature environment.

The electric power semiconductor device may be classified according to its material, and for example, it may include a SiC power semiconductor device or a GaN power semiconductor device. A disadvantage of silicon is that it has unstable characteristics at a high temperatures which may be compensated by manufacturing the electric power semiconductor device using SiC or GaN instead of silicon (Si). The SiC power semiconductor device may be strong at a high temperatures, may have low electric power loss, and may be suitable for the electric vehicles, renewable energy systems, or the like. The GaN power semiconductor device may require high costs, but it may be efficient in terms of speed, and may also be suitable for high-speed charging of a mobile device, or the like.

### SUMMARY

Various example embodiments provide a semiconductor device capable of improving reliability.

A semiconductor device according to various example embodiments may include a substrate including a cell region and a peripheral circuit region outside the cell region, a first conductivity type semiconductor layer on a first surface of the substrate, a second conductivity type doping well region within the first conductivity type semiconductor layer, a gate electrode above the first conductivity type semiconductor layer in the cell region, a gate insulating layer between the first conductivity type semiconductor layer and the gate electrode, a source electrode above the second conductivity type doping well region, a drain electrode on a second surface of the substrate, the second surface being opposite the first surface, a barrier pattern including a first barrier layer above the first conductivity type semiconductor layer, and a second barrier layer on the first barrier layer in the peripheral circuit region, and a first interlayer insulating layer covering an upper surface and a side surface of the gate electrode, and the first interlayer insulating layer is between the first barrier layer and the second barrier layer. The second barrier layer penetrates at least a portion of the first interlayer insulating layer to be connected to the first barrier layer.

A semiconductor device according to other various example embodiments may include a substrate including a cell region and an edge region surrounding the cell region, a first conductivity type semiconductor layer on a first surface of the substrate, a gate electrode above the first conductivity type semiconductor layer in the cell region, a second conductivity type doping well region within the first conductivity type semiconductor layer in the cell region, a first interlayer insulating layer covering an upper surface and a side surface of the gate electrode, a source electrode above the second conductivity type doping well region in the cell region, a drain electrode on a second surface facing the first surface of the substrate, and a barrier pattern including a first barrier layer above the first conductivity type semiconductor layer, the first barrier layer including a material the same as a material of the gate electrode, a second barrier layer on the first barrier layer, and the second barrier layer penetrating at least a portion of the first interlayer insulating layer in the edge region.

A semiconductor device according to other various example embodiments may include a substrate, a first conductivity type semiconductor layer on a first surface of the substrate, a second conductivity type doping well region within the first conductivity type semiconductor layer, a gate electrode above the first conductivity type semiconductor layer, a first interlayer insulating layer covering an upper surface and a side surface of the gate electrode, a barrier pattern at one side of the gate electrode above the first conductivity type semiconductor layer, a source electrode above the second conductivity type doping well region, a drain electrode on a second surface of the substrate, the second surface being opposite the first surface, and a capping layer covering the source electrode, the barrier pattern, and the first interlayer insulating layer. The barrier pattern comprises a first barrier layer above the first conductivity type semiconductor layer, the first barrier layer including a material the same as a material of the gate electrode, a second barrier layer on the first barrier layer, the second barrier layer penetrating at least a portion of the first interlayer insulating layer, and the second barrier layer including a material the same as a material of the source electrode.

The semiconductor device according to various example embodiments may include a barrier pattern disposed above a first conductive substrate at an edge region, so that it prevents a capping layer covering the barrier pattern from peeling or cracking and prevents external oxygen or moisture from penetrating into the semiconductor device. Thus, reliability of the semiconductor device may be improved.

At least some of the above and other features of the invention are set out in the claims.

### BRIEF DESCRIPTION OF THE DRAWINGS

FIG. 1 is a plan view showing a semiconductor device according to various example embodiments.
FIG. 2 is a cross-sectional view showing the semiconductor device according to various example embodiments.
FIG. 3 is an enlarged cross-sectional view of a region S1 of FIG. 2.
FIG. 4 is an enlarged cross-sectional view of a region S2 of FIG. 2.
FIGS. 5 to 12 are cross-sectional views corresponding to the region S2 of FIG. 2 showing a barrier pattern of the semiconductor device according to some example embodiments.
FIG. 13 and FIG. 14 are plan views showing a semiconductor device according to some example embodiments.
FIG. 15 is a cross-sectional view showing the semiconductor device according to various example embodiments relating to FIG. 14.
FIG. 16 is a plan view showing a semiconductor device according to some example embodiments.
FIGS. 17A to 17C are cross-sectional views taken along a line A-A' of FIG. 16.
FIGS. 18 to 26 are process cross-sectional views sequentially showing a method for manufacturing the semiconductor device according to various example embodiments.

### DETAILED DESCRIPTION

Various example embodiments of the present disclosure will be described more fully hereinafter with reference to the accompanying drawings so that those skilled in the art may easily implement the example embodiments. The example embodiments may be modified in various different ways, all without departing from the scope of the present disclosure.

In order to clearly describe various example embodiments, parts or portions that are irrelevant to the description are omitted, and identical or similar constituent elements throughout the specification are denoted by the same reference numerals.

Further, in the drawings, the size and thickness of each element are arbitrarily illustrated for ease of description, and example embodiments are not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

Throughout the specification, it will be understood that when an element such as a layer, film, region, area, or substrate is referred to as being "on" or "above" another element, it may be directly on the other element or intervening elements may also be present. In contrast, when an element is referred to as being "directly on" another element, there are no intervening elements present. Furthermore, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Furthermore, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

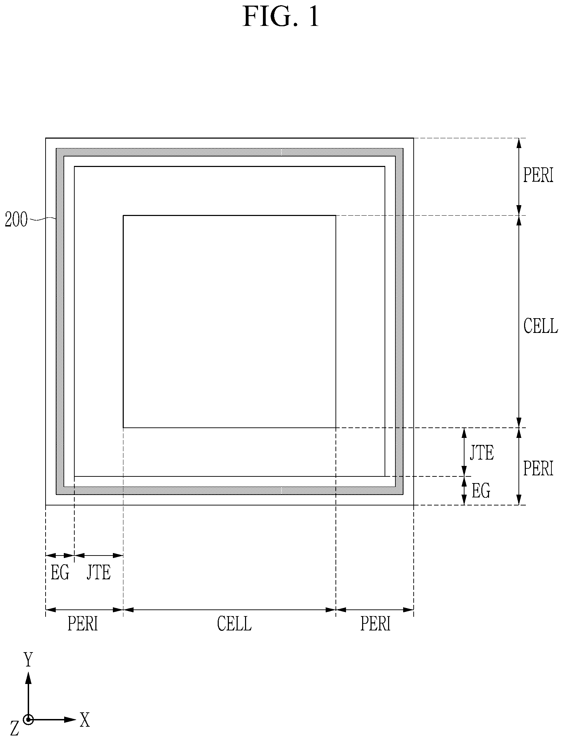

Hereinafter, a semiconductor device according to various example embodiments will be described with reference to FIGS. 1 to 4.

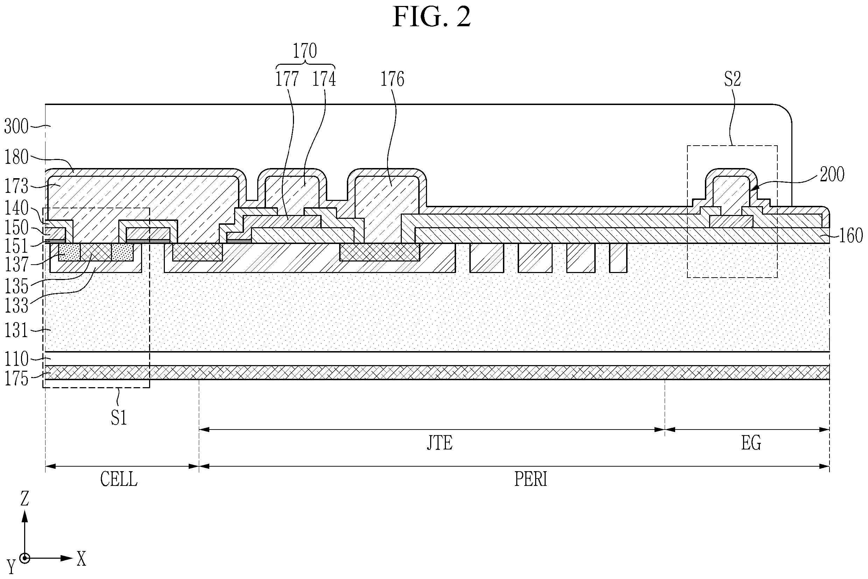

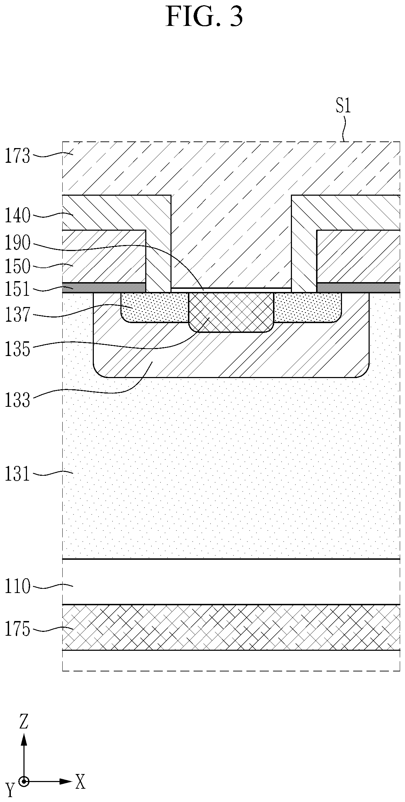

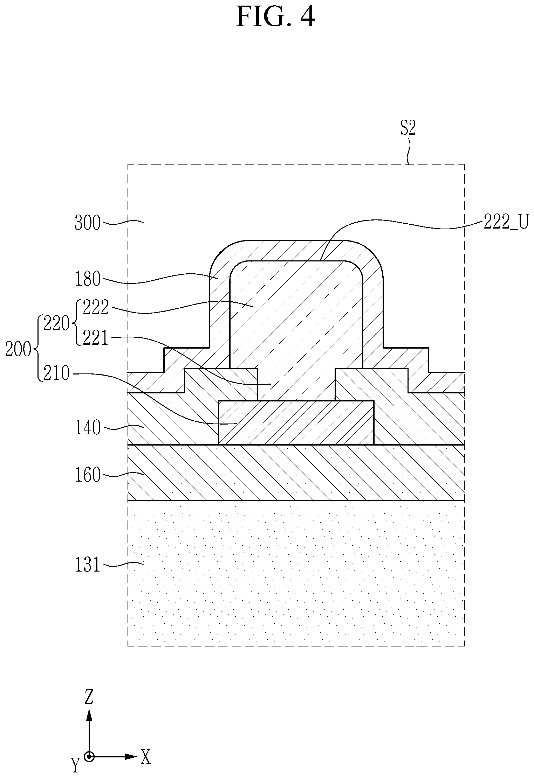

FIG. 1 is a plan view showing the semiconductor device according to various example embodiments. FIG. 2 is a cross-sectional view showing the semiconductor device according to various example embodiments. FIG. 3 is an enlarged cross-sectional view of a region S1 of FIG. 2. FIG. 4 is an enlarged cross-sectional view of a region S2 of FIG. 2.

First, referring to FIG. 1 and FIG. 2, the semiconductor device according to various example embodiments may include a substrate 110, a first conductivity type semiconductor layer 131 disposed on a first surface of the substrate 110, a second conductivity type doping well region 133 disposed within the first conductivity type semiconductor layer 131, a gate electrode 150 disposed above the first conductivity type semiconductor layer 131 and the second conductivity type doping well region 133, a gate insulating layer 151 disposed between the first conductivity type semiconductor layer 131 and the gate electrode 150, a first interlayer insulating layer 140 covering upper and side surfaces of the gate electrode 150, a source electrode 173 disposed above the second conductivity type doping well region 133, a drain electrode 175 disposed on a second surface of the substrate 110, and a barrier pattern 200 disposed above the first conductivity type semiconductor layer 131.

The substrate 110 may be a semiconductor substrate including SiC. For example, the substrate 110 may be formed of a 4H SiC substrate. In some example embodiments, the substrate 110 may be formed of a 3C SiC substrate, a 6H SiC substrate, or the like. However, example embodiments are not limited thereto. The substrate 110 may be doped with a first conductivity type impurity. For example, the first conductivity type impurity may be an n-type impurity. In other words, the substrate 110 may be doped with the n-type impurity. The substrate 110 may be doped with the n-type impurity with a high concentration. A resistivity of the substrate 110 may be greater than or equal to about 0.005 Ωcm and less than or equal to about 0.035 Ωcm. A thickness of the substrate 110 may be about 200 µm or more and about 700 µm or less. A material, a doping type, a doping concentration, a resistivity, a thickness, and the like of the substrate 110 are not limited thereto, and may be variously changed. The substrate 110 may include the first surface and the second surface facing each other. The first surface of the substrate 110 may be an upper surface of the substrate 110, and the second surface of the substrate 110 may be a lower surface of the substrate 110.

In various example embodiments, the substrate 110 may include a cell region CELL and a peripheral circuit region PERI surrounding the cell region CELL. Additionally, the peripheral circuit region PERI may include a junction end region (or a junction termination region) JTE surrounding the cell region CELL and an edge region EG surrounding the junction end region JTE.

A field effect transistor (FET) of the semiconductor device according to various example embodiments may be disposed at the cell region CELL. In this case, the field effect transistor of the semiconductor device according to various example embodiments may be a SiC field-effect transistor (FET), but example embodiments are not limited thereto.

The edge region EG may be disposed outside the cell region CELL. The edge region EG may surround the cell region CELL. For example, as shown in FIG. 1, the edge region EG may be disposed at one side and the other side of the cell region CELL along a first direction (an X direction), and may be disposed above one side and the other side of the cell region CELL along a second direction (a Y direction). However, example embodiments are not limited thereto, and the edge region EG may be disposed on at least one side of the cell region CELL on a plane. The barrier pattern 200 of the semiconductor device according to various example embodiments may be disposed at the edge region EG.

The junction end region JTE may be disposed between the cell region CELL and the edge region EG. The junction end region JTE may surround the cell region CELL. For example, as shown in FIG. 1, the junction end region JTE may be disposed at one side and the other side of the cell region CELL along the first direction (the X direction), and may be disposed above one side and the other side of the cell region CELL along the second direction (the Y direction). However, example embodiments are not limited thereto, and the junction end region JTE may be disposed at a portion between the cell region CELL and the edge region EG. A gate connection structure 170 for connecting the gate electrode 150 to an external circuit and/or a contact electrode 176 for connecting the first conductivity type semiconductor layer 131 to an external circuit may be disposed at the junction end region JTE.

The first conductivity type semiconductor layer 131 may be disposed on the first surface (that is, the upper surface) of the substrate 110. In the cell region CELL, the junction end region JTE, and the edge region EG, the first conductivity type semiconductor layer 131 may be disposed on the substrate 110. A lower surface of the first conductivity type semiconductor layer 131 may be in contact with the upper surface of the substrate 110. However, example embodiments are not limited thereto, and another desired (and/or alternatively predetermined) layer may be further disposed between the substrate 110 and the first conductivity type semiconductor layer 131. The first conductivity type semiconductor layer 131 may be an epitaxial layer formed from the substrate 110 using epitaxial growth. The first conductivity type semiconductor layer 131 may include SiC. For example, the first conductivity type semiconductor layer 131 may include 4H SiC. The first conductivity type semiconductor layer 131 may be doped with an n-type impurity. The first conductivity type semiconductor layer 131 may be doped with the n-type impurity with a low concentration. A doping concentration of the first conductivity type semiconductor layer 131 may be lower than a doping concentration of the substrate 110.

In the cell region CELL and the junction end region JTE, the second conductivity type doping well region 133 may be disposed within the first conductivity type semiconductor layer 131. The second conductivity type doping well region 133 may not be disposed at the edge region EG. The second conductivity type doping well region 133 may be disposed at an upper portion of the first conductivity type semiconductor layer 131. The second conductivity type doping well region 133 may be in contact with a lower surface of the second conductivity type doping layer 135 that will be described later. The second conductivity type doping well region 133 may surround a lower surface and a side surface of a first conductivity type doping layer 137 that will be described later. In various example embodiments, at least some regions of an upper surface of the second conductivity type doping well region 133 may overlap at least a portion of the gate electrode 150 to be described later and at least a portion of the gate insulating layer 151 to be described later in a third direction (a Z direction). Here, the third direction (the Z direction) may mean a vertical direction of the substrate 110, the vertical direction being perpendicular to an upper surface of the substrate 110.

In various example embodiments, the second conductivity type doping well region 133 may extend from an upper surface of the first conductivity type semiconductor layer 131 to a lower surface direction of the first conductivity type semiconductor layer 131. That is, the second conductivity type doping well region 133 may extend from the upper surface of the first conductivity type semiconductor layer 131 in the third direction (the Z direction). The second conductivity type doping well region 133 may be formed in at least some regions of the first conductivity type semiconductor layer 131 through an ion implantation method.

The second conductivity type doping well region 133 may include SiC. For example, the second conductivity type doping well region 133 may include 4H SiC. The second conductivity type doping well region 133 may be doped with a p-type impurity. The second conductivity type doping well region 133 may be doped with the p-type impurity with a low concentration. A doping concentration of the second conductivity type doping well region 133 may be about 1 *1017 cm-3 or more and about 1 *1019 cm-3 or less. A material, a doping type, a doping concentration, and the like of the second conductivity type doping well region 133 are not limited thereto, and may be variously changed.

The semiconductor device according to various example embodiments may further include the second conductivity type doping layer 135 and the first conductivity type doping layer 137 disposed at an upper portion of the first conductivity type semiconductor layer 131.

In the cell region CELL and the junction end region JTE, the second conductivity type doping layer 135 may be disposed within the second conductivity type doping well region 133. The second conductivity type doping layer 135 may not be disposed at the edge region EG. The second conductivity type doping layer 135 may be disposed at the upper portion of the first conductivity type semiconductor layer 131, and may have an upper surface that is in direct contact with a lower surface of a silicide layer 190 connected to the source electrode 173 that will be described later. In various example embodiments, at least some regions of an upper surface of the second conductivity type doping layer 135 may be in contact with a lower surface of the silicide layer 190 that will be described later, but example embodiments are not limited thereto. For example, the at least some regions of the upper surface of the second conductivity type doping layer 135 may be in contact with a lower surface of the source electrode 173. In this case, the second conductivity type doping layer 135 may have a width wider than that of the source electrode 173. In various example embodiments, the second conductivity type doping layer 135 may extend from an upper surface of the first conductivity type semiconductor layer 131 in the third direction (the Z direction). In this case, a thickness of the second conductivity type doping layer 135 along the third direction (the Z direction) may be smaller than a thickness of the second conductivity type doping well region 133 along the third direction (the Z direction). Additionally, the second conductivity type doping layer 135 may have a narrower width than that of the second conductivity type doping well region 133. That is, the second conductivity type doping layer 135 may be buried within the second conductivity type doping well region 133. The second conductivity type doping layer 135 may be formed in at least some regions of the second conductivity type doping well region 133 through an ion implantation method.

The second conductivity type doping layer 135 may include SiC. For example, the second conductivity type doping layer 135 may include 4H SiC. The second conductivity type doping layer 135 may be doped with a p-type impurity. The second conductivity type doping layer 135 may form an ohmic contact with the source electrode 173. To this end, the second conductivity type doping layer 135 may be doped with the p-type impurity with a high concentration. In various example embodiments, a doping concentration of the second conductivity type doping layer 135 may be higher than a doping concentration of the second conductivity type doping well region 133. The doping concentration of the second conductivity type doping layer 135 may be about 1 *1018 cm-3 or more and about 5*1020 cm-3 or less. A material, a doping type, a doping concentration, and the like of the second conductivity type doping layer 135 are not limited thereto, and may be variously changed.

In the cell region CELL, the first conductivity type doping layer 137 may be disposed within the second conductivity type doping well region 133. The first conductivity type doping layer 137 may not be disposed at the junction end region JTE and the edge region EG. The first conductivity type doping layer 137 may be disposed at an upper portion of the first conductivity type semiconductor layer 131, and may surround both side surfaces of the second conductivity type doping layer 135. An upper surface of the first conductivity type doping layer 137 may overlap at least a portion of the gate electrode 150 and at least a portion of the gate insulating layer 151 that will be described later in the third direction (the Z direction). In addition, the upper surface of the first conductivity type doping layer 137 may overlap at least a portion of the source electrode 173 that will be described later in the third direction (the Z direction), but example embodiments are not limited thereto. The upper surface of the first conductivity type doping layer 137 may be in direct contact with the gate insulating layer 151 that will be described later.

In various example embodiments, the first conductivity type doping layer 137 may extend from an upper surface of the first conductivity type semiconductor layer 131 in the third direction (the Z direction). The first conductivity type doping layer 137 may be buried within the second conductivity type doping well region 133. In this case, a thickness of the first conductivity type doping layer 137 along the third direction (the Z direction) may be smaller than a thickness of the second conductivity type doping well region 133 along the third direction (the Z direction).

The first conductivity type doping layer 137 may be a doping region formed within the first conductivity type semiconductor layer 131 using an ion implantation process. The first conductivity type doping layer 137 may include SiC. For example, the first conductivity type doping layer 137 may include 4H SiC. The first conductivity type doping layer 137 may be doped with an n-type impurity. The first conductivity type doping layer 137 may be doped with the n-type impurity with a high concentration. A doping concentration of the first conductivity type doping layer 137 may be about 1*1018 cm-3 or more and about 5*1020 cm-3 or less. A material, a doping type, a doping concentration, and the like of the first conductivity type doping layer 137 are not limited thereto, and may be variously changed.

In the cell region CELL, the gate electrode 150 may be disposed above the first conductivity type semiconductor layer 131. The gate electrode 150 may not be disposed at the junction end region JTE and the edge region EG. The gate electrode 150 may be spaced apart from the first conductivity type semiconductor layer 131. For example, the gate electrode 150 may be spaced apart from the first conductivity type semiconductor layer 131 by the gate insulating layer 151 in a vertical direction (e.g., a vertical direction being a direction perpendicular to an upper surface of the substrate 110 or the third direction (the Z direction)). The semiconductor device according to various example embodiments may have a planar-type gate structure. That is, in the semiconductor device according to various example embodiments, the gate electrode 150 may have a flat plate shape with flat upper and lower surfaces, and a lower surface of the gate electrode 150 may be disposed at a higher level than that of an uppermost surface of the first conductivity type semiconductor layer 131. However, example embodiments are not limited thereto, and the semiconductor device according to various example embodiments may have a trench-type gate structure. For example, in the semiconductor device according to various example embodiments, a trench having a desired (and/or alternatively predetermined) depth may be formed at the first conductivity type semiconductor layer 131, and the gate electrode 150 may be disposed inside the trench to be spaced apart from the first conductivity type semiconductor layer 131 in the third direction (the Z direction). Additionally, the gate electrode 150 may be disposed to be spaced apart from the first conductivity type semiconductor layer 131 in a horizontal direction (the first direction (the X direction) and/or the second direction (the Y direction)).

In various example embodiments, the gate electrode 150 may overlap the second conductivity type doping well region 133 and the first conductivity type doping layer 137 in the third direction (the Z direction). The gate electrode 150 may include a conductive material. For example, the gate electrode 150 may include polysilicon doped with an impurity. As another example, the gate electrode 150 may include a metal, a metal alloy, conductive metal nitride, metal silicide, a doped semiconductor material, conductive metal oxide, conductive metal oxynitride, or a combination thereof. However, example embodiments are not limited thereto. The gate electrode 150 may be made of a single layer or multiple layers.

The gate insulating layer 151 may be disposed between the first conductivity type semiconductor layer 131 and the gate electrode 150. That is, the gate insulating layer 151 may be disposed below the gate electrode 150, and may cover the lower surface of the gate electrode 150. The gate electrode 150 may be insulated from the first conductivity type semiconductor layer 131 by the gate insulating layer 151. A thickness of the gate insulating layer 151 may be almost constant. In various example embodiments, the gate insulating layer 151 may overlap the second conductivity type doping well region 133 and the first conductivity type doping layer 137 in the third direction (the Z direction). A lower surface of the gate insulating layer 151 may directly contact the second conductivity type doping well region 133 and the first conductivity type doping layer 137, but example embodiments are not limited thereto. The gate insulating layer 151 may include an insulating material. For example, the gate insulating layer 151 may include SiO2. However, example embodiments are not limited thereto, and a material of the gate insulating layer 151 may be variously changed. As another example, the gate insulating layer 151 may include SiN, SiON, SiC, SiCN, or a combination thereof. The gate insulating layer 151 may be made of a single layer or multiple layers.

At the cell region CELL, the junction end region JTE, and the edge region EG, the first interlayer insulating layer 140 may be disposed above the first conductivity type semiconductor layer 131. For example, at the cell region CELL, the first interlayer insulating layer 140 may be disposed on the gate electrode 150. Specifically, the first interlayer insulating layer 140 may cover upper and side surfaces of the gate electrode 150. The first interlayer insulating layer 140 may cover a side surface of the gate insulating layer 151. The first interlayer insulating layer 140 may be disposed on the first conductivity type doping layer 137. The first interlayer insulating layer 140 may have a lower surface in contact with at least a portion of an upper surface of the first conductivity type doping layer 137. The gate electrode 150 may be insulated from the source electrode 173 by the first interlayer insulating layer 140.

Additionally, the first interlayer insulating layer 140 may be disposed above the first conductivity type semiconductor layer 131 at the junction end region JTE and the edge region EG. At the junction end region JTE, the first interlayer insulating layer 140 may be disposed on a first gate connection wire 177 that will be described later. A detailed description thereof will be provided later in a description of the junction end region JTE and the edge region EG.

The first interlayer insulating layer 140 may include an insulating material. In various example embodiments, the first interlayer insulating layer 140 may include the same insulating material as that of the gate insulating layer 151. For example, the first interlayer insulating layer 140 may include SiO2. However, example embodiments are not limited thereto, and the first interlayer insulating layer 140 may include various types of insulating materials for insulating the gate electrode 150 from the source electrode 173. For example, the first interlayer insulating layer 140 may include SiOP, SiN, SiON, or a combination thereof. The first interlayer insulating layer 140 may be made of a single layer or multiple layers. If the first interlayer insulating layer 140 is made of the same material as that of the gate insulating layer 151, a boundary between the first interlayer insulating layer 140 and the gate insulating layer 151 may not be clearly distinguished at a portion where the first interlayer insulating layer 140 and the gate insulating layer 151 are in contact with each other.

In the cell region CELL, the source electrode 173 may be disposed above the second conductivity type doping well region 133. The source electrode 173 may not be disposed at the junction end region JTE and the edge region EG. The second conductivity type doping layer 135 and the first conductivity type doping layer 137 may be disposed between the source electrode 173 and the second conductivity type doping well region 133. The source electrode 173 may be electrically connected to the second conductivity type doping well region 133 by the second conductivity type doping layer 135. The source electrode 173 may be disposed at both sides of the gate electrode 150. However, example embodiments are not limited thereto, and the source electrode 173 may be disposed only at one side of the gate electrode 150. The first interlayer insulating layer 140 may be disposed between the source electrode 173 and the gate electrode 150. A current or a voltage may be provided to the semiconductor device according to various example embodiments through the source electrode 173. The source electrode 173 may be spaced apart from the gate electrode 150 by the first interlayer insulating layer 140. The source electrode 173 may be in contact with a side surface of the first interlayer insulating layer 140.

Various example embodiments have described that a portion of the source electrode 173 disposed between gate electrodes 150 adjacent to each other in the first direction (the X direction) overlaps the second conductivity type doping layer 135 and the first conductivity type doping layer 137 in the third direction (the Z direction), but example embodiments are not limited thereto. For example, the portion of the source electrode 173 disposed between the gate electrodes 150 adjacent to each other in the first direction (the X direction) may not overlap the first conductivity type doping layer 137 in the third direction (the Z direction). In this case, an upper surface of the first conductivity type doping layer 137 may be covered by the gate insulating layer 151.

The source electrode 173 may include a conductive material. For example, the source electrode 173 may include a metal, a metal alloy, conductive metal nitride, metal silicide, a doped semiconductor material, conductive metal oxide, conductive metal oxynitride, or the like. For example, the source electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but example embodiments are not limited thereto. The source electrode 173 may be made of a single layer or multiple layers.

The semiconductor device according to various example embodiments may further include the silicide layer 190 disposed between the source electrode 173 and the second conductivity type doping layer 135 and between the source electrode 173 and the first conductivity type doping layer 137.

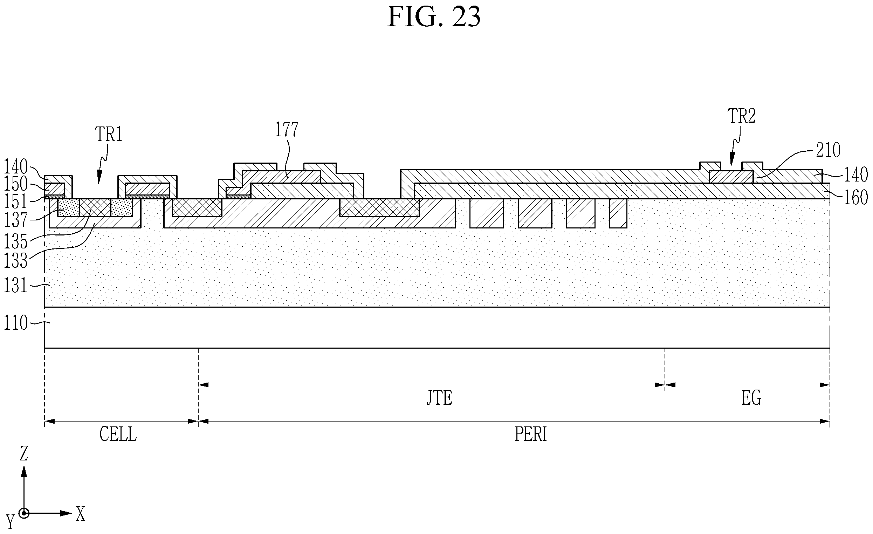

The silicide layer 190 may be conformally disposed along an interface between the source electrode 173 and the second conductivity type doping layer 135 and an interface between the source electrode 173 and the first conductivity type doping layer 137. A lower surface of the silicide layer 190 may be in direct contact with the second conductivity type doping layer 135 and the first conductivity type doping layer 137. An upper surface of the silicide layer 190 may be in direct contact with the source electrode 173. The silicide layer 190 may include a metal silicide material. For example, the silicide layer 190 may include tungsten silicide (WSi), titanium silicide (TiSi), cobalt silicide (CoSi), nickel silicide (NiSi), or a combination thereof. However, example embodiments are not limited thereto. In a manufacturing process of the semiconductor device according to various example embodiments, a silicidation process may be performed on upper surfaces of the second conductivity type doping layer 135 and the first conductivity type doping layer 137 exposed by a first trench TR1 of FIG. 23 to form the silicide layer 190. However, example embodiments are not limited thereto, and after the source electrode 173 is formed, an annealing process may be subsequently performed to reduce a contact resistance between the second conductivity type doping layer 135 and the source electrode 173 and a contact resistance between the first conductivity type doping layer 137 and the source electrode 173. Accordingly, the silicide layer 190 may be formed along the interface between the source electrode 173 and the second conductivity type doping layer 135 and the interface between the source electrode 173 and the first conductivity type doping layer 137.

Hereinafter, the junction end region of the semiconductor device according to various example embodiments will be described.

In various example embodiments, the junction end region JTE may be disposed outside the cell region CELL. For example, the junction end region JTE may surround the cell region CELL. The junction end region JTE may be disposed between the cell region CELL and the edge region EG. The junction end region JTE may improve performance of a device disposed within the cell region CELL by reducing concentration of an electric field. For example, the junction end region JTE may reduce a leakage current by increasing a breakdown voltage of the device (e.g., a field effect transistor (FET)) disposed within the cell region CELL.

The second conductivity type doping well region 133 and the second conductivity type doping layer 135 disposed within the first conductivity type semiconductor layer 131, a second interlayer insulating layer 160 disposed on the first conductivity type semiconductor layer 131, and the first interlayer insulating layer 140 disposed on the second interlayer insulating layer 160 may be disposed at the junction end region JTE of the semiconductor device according to various example embodiments. In addition, a wiring structure may be further disposed at the junction end region JTE of the semiconductor device according to various example embodiments. The wiring structure may include the gate connection structure 170 for connecting the gate electrode 150 to the external circuit and the contact electrode 176 for connecting the first conductivity type semiconductor layer 131 to the external circuit.

In the junction end region JTE, the second interlayer insulating layer 160 may be disposed on the first conductivity type semiconductor layer 131. The second interlayer insulating layer 160 may not be disposed at the cell region CELL. The second interlayer insulating layer 160 may be disposed between the first conductivity type semiconductor layer 131 and the first interlayer insulating layer 140. The second interlayer insulating layer 160 may overlap the second conductivity type doping layer 135 and the first conductivity type semiconductor layer 131 in the third direction (the Z direction). A lower surface of the second interlayer insulating layer 160 may be in direct contact with the second conductivity type doping layer 135 and the first conductivity type semiconductor layer 131. In one example, the second interlayer insulating layer (160) may not overlap the second conductivity type doping well region (133) in a vertical direction of the substrate (110) in the cell region (CELL).

The second interlayer insulating layer 160 may include an insulating material. The second interlayer insulating layer 160 may include the same insulating material as that of the first interlayer insulating layer 140, but example embodiments are not limited thereto. For example, the second interlayer insulating layer 160 may include SiO2. However, example embodiments are not limited thereto, and the second interlayer insulating layer 160 may include various types of insulating materials. For example, the second interlayer insulating layer 160 may include SiOP, SiN, SiON, or a combination thereof. The second interlayer insulating layer 160 may be made of a single layer or multiple layers. If the second interlayer insulating layer 160 is made of the same material as that of the first interlayer insulating layer 140, a boundary between the second interlayer insulating layer 160 and the first interlayer insulating layer 140 may not be clearly distinguished at a portion where the second interlayer insulating layer 160 and the first interlayer insulating layer 140 are in contact with each other.

The gate connection structure 170 of the semiconductor device according to various example embodiments may include the first gate connection wire 177 and a second gate connection wire 174.

The first gate connection wire 177 may be disposed above or on the first conductivity type semiconductor layer 131 and the second interlayer insulating layer 160. The gate insulating layer 151 may be further disposed between the first gate connection wire 177 and the first conductivity type semiconductor layer 131. The first gate connection wire 177 may be electrically connected to the gate electrode 150 to apply a gate signal (e.g., a gate voltage) to the gate electrode 150. The first gate connection wire 177 may be covered by the first interlayer insulating layer 140. For example, the first interlayer insulating layer 140 may be disposed between the first gate connection wire 177 and the source electrode 173.

The first gate connection wire 177 may include a conductive material. The first gate connection wire 177 may include the same material as that of the gate electrode 150. In various example embodiments, the first gate connection wire 177 may be simultaneously formed in the same process as that of the gate electrode 150. For example, the first gate connection wire 177 may include polysilicon doped with an impurity. As another example, the first gate connection wire 177 may include a metal, a metal alloy, conductive metal nitride, metal silicide, a doped semiconductor material, conductive metal oxide, conductive metal oxynitride, or a combination thereof. However, example embodiments are not limited thereto. The first gate connection wire 177 may be made of a single layer or multiple layers. At least a portion of the first gate connection wire 177 may form the same layer as that of the gate electrode 150.

The second gate connection wire 174 may be disposed on the first gate connection wire 177. The second gate connection wire 174 may be electrically connected to the first gate connection wire 177 by penetrating the first interlayer insulating layer 140. The second gate connection wire 174 may overlap the first gate connection wire 177 and the first interlayer insulating layer 140 in the third direction (the Z direction). A lower surface of the second gate connection wire 174 may be in direct contact with the first gate connection wire 177 and the first interlayer insulating layer 140. The second gate connection wire 174 may include a bent portion at a portion penetrating the first interlayer insulating layer 140, but example embodiments are not limited thereto.

In various example embodiments, an upper surface of the second gate connection wire 174 may be disposed at substantially the same level as that of an upper surface of the source electrode 173. That is, the upper surface of the second gate connection wire 174 may be disposed at substantially the same distance from the upper surface of the source electrode 173 and an upper surface of the substrate 110. This may be due to a process characteristic of simultaneously forming the second gate connection wire 174 and the source electrode 173 in the same process.

The second gate connection wire 174 may include a conductive material. The second gate connection wire 174 may include the same material as that of the source electrode 173. For example, the source electrode 173 may include a metal, a metal alloy, conductive metal nitride, metal silicide, a doped semiconductor material, conductive metal oxide, conductive metal oxynitride, or the like. However, example embodiments are not limited thereto.

The contact electrode 176 may be disposed above the first conductivity type semiconductor layer 131. For example, the contact electrode 176 may be disposed on the second conductive type doping layer 135 disposed at the junction end region JTE. The contact electrode 176 may be electrically connected to the second conductivity type doping layer 135 and/or the first conductivity type semiconductor layer 131 to supply a power voltage to the second conductivity type doping layer 135 and/or the first conductivity type semiconductor layer 131. The contact electrode 176 may include a conductive material. The contact electrode 176 may include the same material as that of the source electrode 173 and/or that of the second gate connection wire 174, but example embodiments are not limited thereto.

Hereinafter, the edge region of the semiconductor device according to various example embodiments will be described further with reference to FIG. 4.

In various example embodiments, the edge region EG may be disposed outside the cell region CELL. For example, the edge region EG may surround the cell region CELL and the junction end region JTE.

The edge region EG of the semiconductor device according to various example embodiments may include the second interlayer insulating layer 160, the first interlayer insulating layer 140, and the barrier pattern 200 sequentially disposed above or on the first conductivity type semiconductor layer 131.

In the edge region EG, the barrier pattern 200 may be disposed above the first conductivity type semiconductor layer 131. For example, in the edge region EG, the barrier pattern 200 may be disposed directly above the second interlayer insulating layer 160 that is disposed on the first conductivity type semiconductor layer 131, but example embodiments are not limited thereto. In various example embodiments, the barrier pattern 200 may protrude in the third direction (the Z direction). For example, the barrier pattern 200 may protrude from an upper surface of the second interlayer insulating layer 160 in the third direction (the Z direction). The barrier pattern 200 may be disposed outside the gate electrode 150.

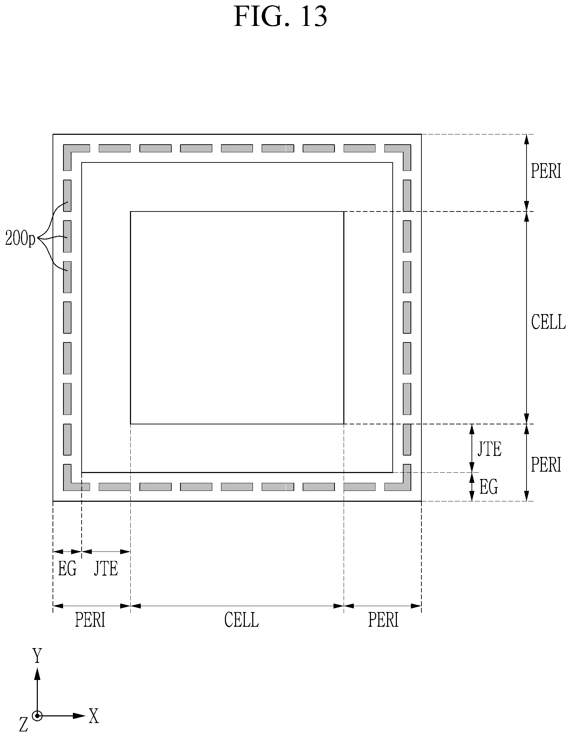

In various example embodiments, the barrier pattern 200 may surround the cell region CELL. The barrier pattern 200 may extend to completely surround the cell region CELL. For example, the barrier pattern 200 may extend from both sides of the cell region CELL along the first direction (the X direction) in the second direction (the Y direction), and may extend from both sides of the cell region CELL along the second direction (the Y direction) in the first direction (the X direction). The barrier pattern 200 may have a quadrangle ring shape. However, example embodiments are not limited thereto, and a shape of the barrier pattern 200 may be variously changed within the edge region EG. A description thereof will be provided later in a description of the drawings including FIG. 13.

The barrier pattern 200 of the semiconductor device according to various example embodiments may include a first barrier layer 210 disposed on the second interlayer insulating layer 160 and a second barrier layer 220 disposed on the first barrier layer 210 and penetrating at least a portion of the first interlayer insulating layer 140.

The first barrier layer 210 may be disposed on the second interlayer insulating layer 160 disposed on the first conductivity type semiconductor layer 131. The first barrier layer 210 may be covered by the first interlayer insulating layer 140. That is, the first barrier layer 210 may be disposed between the second interlayer insulating layer 160 and the first interlayer insulating layer 140. A lower surface of the first barrier layer 210 may be in direct contact with the second interlayer insulating layer 160. Upper and side surfaces of the first barrier layer 210 may be in direct contact with the first interlayer insulating layer 140.

In various example embodiments, a thickness of the first barrier layer 210 along the third direction (the Z direction) may be substantially the same as a thickness of the gate electrode 150 along the third direction (the Z direction) and/or a thickness of the first gate connection wire 177 along the third direction (the Z direction). This may be due to a process characteristic in which the first barrier layer 210 is simultaneously formed in the same process as that of the gate electrode 150 and/or that of the first gate connection wire 177. On the other hand, the first barrier layer 210 may be formed on the second interlayer insulating layer 160 and the gate electrode 150 may be formed above the first conductivity type semiconductor layer 131, so that an upper surface of the first barrier layer 210 is disposed at a higher level than that of an upper surface of the gate electrode 150. That is, the upper surface of the first barrier layer 210 may be disposed farther from an upper surface of the substrate 110 than the upper surface of the gate electrode 150.

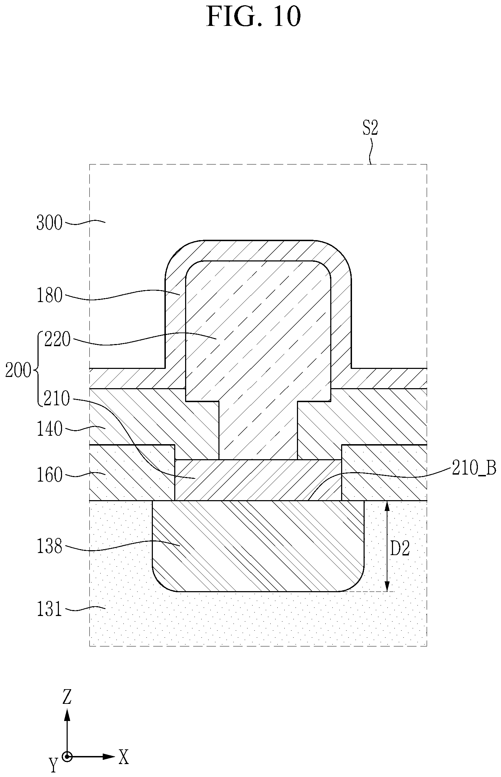

In various example embodiments, the first barrier layer 210 may be disposed to be spaced apart from the first conductivity type semiconductor layer 131. For example, the second interlayer insulating layer 160 may be disposed between the first barrier layer 210 and the first conductivity type semiconductor layer 131, so that the first barrier layer 210 and the first conductivity type semiconductor layer 131 are not electrically connected. However, example embodiments are not limited thereto, and the first barrier layer 210 may be electrically connected to the first conductivity type semiconductor layer 131. A description thereof will be provided later in a description of FIG. 10.

The first barrier layer 210 may include a conductive material. The first barrier layer 210 may include the same material as that of the gate electrode 150 and/or that of the first gate connection wire 177. In various example embodiments, the first barrier layer 210 may be simultaneously formed in the same process as that of the gate electrode 150 and/or that of the first gate connection wire 177. For example, the first barrier layer 210 may include polysilicon doped with an impurity. As another example, the first barrier layer 210 may include a metal, a metal alloy, conductive metal nitride, metal silicide, a doped semiconductor material, conductive metal oxide, conductive metal oxynitride, or a combination thereof. However, example embodiments are not limited thereto. The first barrier layer 210 may be made of a single layer or multiple layers. At least a portion of the first barrier layer 210 may form the same layer as that of the gate electrode 150.

The second barrier layer 220 may be disposed on the first barrier layer 210. The second barrier layer 220 may penetrate the first interlayer insulating layer 140 to be connected to the first barrier layer 210. The second barrier layer 220 may include a bent portion at a portion penetrating the first interlayer insulating layer 140, but example embodiments are not limited thereto. The second barrier layer 220 may include a conductive material. The second barrier layer 220 may include the same material as that of the source electrode 173 and/or that of the second gate connection wire 174. For example, the source electrode 173 may include a metal, a metal alloy, conductive metal nitride, metal silicide, a doped semiconductor material, conductive metal oxide, conductive metal oxynitride, or the like. However, example embodiments are not limited thereto. The second barrier layer 220 may be made of a single layer or multiple layers.

The second barrier layer 220 of the semiconductor device according to various example embodiments may include a first portion 221 disposed on the first barrier layer 210 and a second portion 222 disposed on the first portion 221.

The first portion 221 may penetrate at least a portion of the first interlayer insulating layer 140. For example, the first portion 221 may be connected to the first barrier layer 210 by penetrating the at least a portion of the first interlayer insulating layer 140 disposed on the upper surface of the first barrier layer 210. Accordingly, the first portion 221 may be surrounded by the first interlayer insulating layer 140. A lower surface of the first portion 221 may contact the first barrier layer 210, but example embodiments are not limited thereto. A side surface of the first portion 221 may be in contact with the first interlayer insulating layer 140.

The second portion 222 may be disposed on the first portion 221. For example, the second portion 222 may be disposed on an upper surface of the first portion 221 and an upper surface of the first interlayer insulating layer 140. In various example embodiments, a width of the second portion 222 along one direction (e.g., the first direction (the X direction)) may be greater than a width of the first portion 221 along one direction (e.g., the first direction (the X direction)). For example, a maximum width of the second portion 222 along one direction (e.g., the first direction (the X direction)) may be greater than a maximum width of the first portion 221 along one direction (e.g., the first direction (the X direction)). A minimum width of the second portion 222 along one direction (e.g., the first direction (the X direction)) may be greater than a minimum width of the first portion 221 along one direction (e.g., the first direction (the X direction)), but example embodiments are not limited thereto. Accordingly, the first interlayer insulating layer 140 may be disposed between at least a portion of the second portion 222 and the first barrier layer 210.

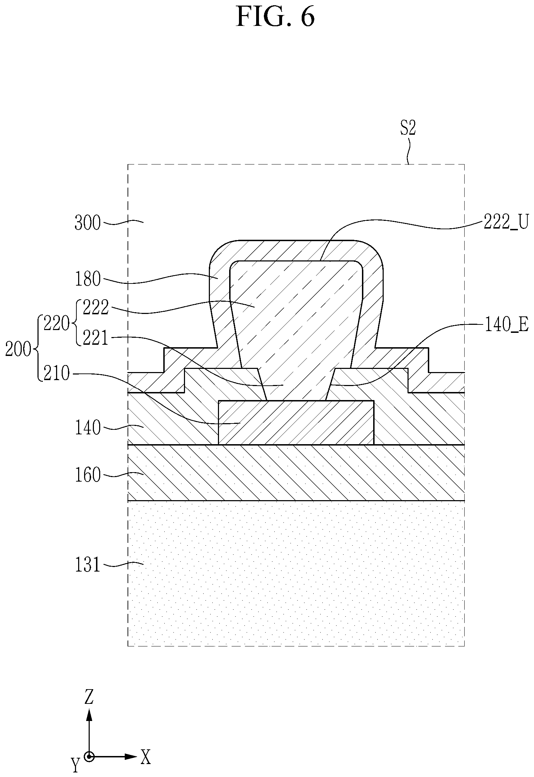

In various example embodiments, an upper surface 222_U of the second portion 222 (as shown in FIG 6, for example) may be disposed at substantially the same level as that of an upper surface of the source electrode 173 and/or that of an upper surface of the second gate connection wire 174. That is, the upper surface 222_U of the second portion 222 may be disposed at substantially the same distance from the upper surface of the source electrode 173 and/or the upper surface of the second gate connection wire 174 and an upper surface of the substrate 110. This may be due to a process characteristic in which the second portion 222 is simultaneously formed in the same process as that of the second gate connection wire 174 and/or that of the source electrode 173. In one example, a distance from an upper surface of the second barrier layer (220) to an upper surface of the substrate (110) is the same as a distance from an upper surface of the source electrode (173) to an upper surface of the substrate (110).

Referring back to FIG. 2, the semiconductor device according to various example embodiments may further include an upper insulating layer 180 covering the source electrode 173 and the barrier pattern 200, and a capping layer 300 disposed on the upper insulating layer 180.

The upper insulating layer 180 may be entirely disposed at the cell region CELL, the junction end region JTE, and the edge region EG. For example, the upper insulating layer 180 may cover the source electrode 173, the gate connection structure 170, the contact electrode 176, and the barrier pattern 200. Additionally, the upper insulating layer 180 may cover the first interlayer insulating layer 140. The upper insulating layer 180 may be conformally disposed on the source electrode 173, the gate connection structure 170, the contact electrode 176, and the barrier pattern 200. Specifically, because the barrier pattern 200 protrudes from the second interlayer insulating layer 160 in the third direction (the Z direction), in the edge region EG, an upper surface of the upper insulating layer 180 may include a portion protruding from the second interlayer insulating layer 160 in the third direction (the Z direction). The upper insulating layer 180 may include an insulating material.

The capping layer 300 may be disposed in the cell region CELL, the junction end region JTE, and the edge region EG. The capping layer 300 may be disposed on the upper insulating layer 180 in the cell region CELL, the junction end region JTE, and the edge region EG. The capping layer 300 may entirely cover the upper insulating layer 180, but the capping layer 300 may include a portion that does not cover the upper insulating layer 180 at an end of the edge region EG.

The capping layer 300 may perform a function protecting the semiconductor device according to various example embodiments. The capping layer 300 may be a layer that prevents doped regions, conductive electrodes, or the like of the semiconductor device according to various example embodiments from being exposed to oxygen or moisture. The capping layer 300 may be formed with a sufficient thickness to completely cover the doped regions, the conductive electrodes, or the like. For example, the capping layer 300 may be formed to cover the source electrode 173, the gate connection structure 170, and the contact electrode 176. The capping layer 300 may include a material with chemical, mechanical, and high temperature stability. For example, the capping layer 300 may be formed of a polymer layer such as polyimide (PI), but example embodiments are not limited thereto. However, example embodiments are not limited thereto, and the capping layer 300 may further include various insulating materials such as SiO2, SiN, SiON, SiC, SiCN, SiOCN, and a combination thereof together with the polymer layer.

In various example embodiments because the barrier pattern 200 protrudes from the second interlayer insulating layer 160 in the third direction (the Z direction), in the edge region EG, an upper surface of the upper insulating layer 180 may include a portion protruding from the second interlayer insulating layer 160 in the third direction (the Z direction). Accordingly, a lower surface of the capping layer 300 may include a portion concave in a direction away from an upper surface of the second interlayer insulating layer 160. That is, the barrier pattern 200 may be disposed at the edge region EG of the semiconductor device according to various example embodiments, so that an area of an interface between the capping layer 300 and the upper insulating layer 180 increases and a stress of the capping layer 300 along a horizontal direction (e.g., the first direction (the X direction) and/or the second direction (the Y direction)) increases. Accordingly, the capping layer 300 may be reduced or prevented from peeling from the upper insulating layer 180, and if a crack occurs within the capping layer 300 outside the barrier pattern 200, the crack may be reduced or prevented from proceeding inside the barrier pattern 200. Accordingly, reliability of the semiconductor device may be improved by limiting or preventing external oxygen or moisture from penetrating into the semiconductor device.

The drain electrode 175 may be disposed on the second side surface of the substrate 110 that is the lower surface. An upper surface of the drain electrode 175 may be in contact with the lower surface of the substrate 110. The drain electrode 175 may be in ohmic contact with the substrate 110. A region in contact with the drain electrode 175 within the substrate 110 may be doped at a relatively high concentration compared with another region. However, example embodiments are not limited thereto, and another desired (and/or alternatively predetermined) layer may be further disposed between the drain electrode 175 and the substrate 110. For example, a silicide layer may be disposed between the drain electrode 175 and the substrate 110. The silicide layer may include a metal silicide material. The drain electrode 175 and the substrate 110 may be electrically and smoothly connected by the metal silicide layer.

The drain electrode 175 may include a conductive material. For example, the drain electrode 175 may include a metal, a metal alloy, conductive metal nitride, metal silicide, a doped semiconductor material, conductive metal oxide, conductive metal oxynitride, or the like. However, example embodiments are not limited thereto. The drain electrode 175 may be made of the same material as that of the source electrode 173, or may be made of a material different from that of the source electrode 173. The drain electrode 175 may be made of a single layer or multiple layers.

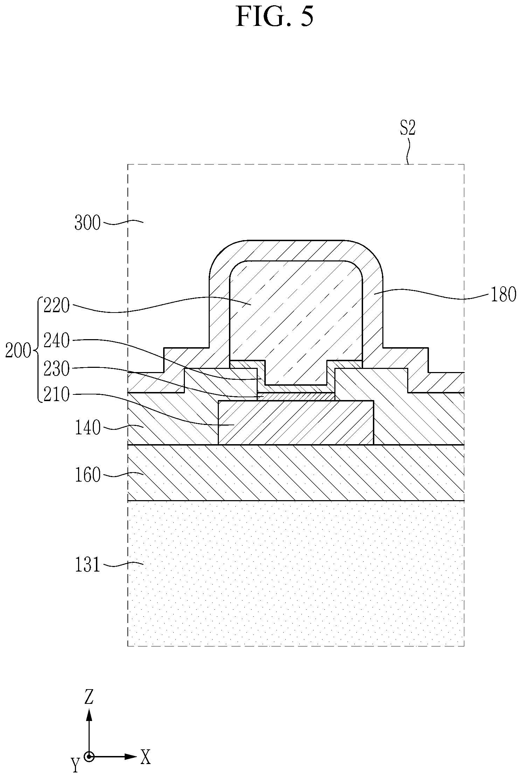

Hereinafter, a barrier pattern of the semiconductor device according to some example embodiments will be described with reference to FIGS. 5 to 12.

FIGS. 5 to 12 are cross-sectional views corresponding to the region S2 of FIG. 2 showing the barrier pattern of the semiconductor device according to some example embodiments.

FIGS. 5 to 12 show various modified examples of the semiconductor device according to various example embodiments shown in FIGS. 1 to 4. Because various example embodiments shown in FIGS. 5 to 12 has the same portion as that of various example embodiments shown in FIGS. 1 to 4, a description thereof will be omitted and a difference between various example embodiments shown in FIGS. 5 to 12 and various example embodiments shown in FIGS. 1 to 4 will be mainly described. Additionally, the same reference numeral is used for a component that is the same as that of the previous embodiment.

Referring to FIG. 5, the barrier pattern 200 of the semiconductor device according to some example embodiments may further include a third barrier layer 230 disposed on the first barrier layer 210 and a fourth barrier layer 240 disposed between the third barrier layer 230 and the second barrier layer 220.

The third barrier layer 230 may be disposed on the first barrier layer 210. The third barrier layer 230 may be conformally disposed along an upper surface profile of the first barrier layer 210. That is, the third barrier layer 230 may be disposed within a space between first interlayer insulating layers 140 disposed on the first barrier layer 210. The third barrier layer 230 may be disposed between the first barrier layer 210 and the second barrier layer 220. A side surface of the third barrier layer 230 may be in direct contact with the first interlayer insulating layer 140. The lower surface of the third barrier layer 230 may be in contact with the first barrier layer 210. The third barrier layer 230 may include a metal silicide material. For example, the third barrier layer 230 may include tungsten silicide (WSi), titanium silicide (TiSi), cobalt silicide (CoSi), nickel silicide (NiSi), or a combination thereof. However, example embodiments are not limited thereto.

The fourth barrier layer 240 may be disposed on the third barrier layer 230. The fourth barrier layer 240 may be conformally disposed along profiles of a portion of an upper surface and a portion of a side surface of the first interlayer insulating layer 140 and an upper surface of the third barrier layer 230. Accordingly, the first interlayer insulating layer 140 may be disposed between at least a portion of the fourth barrier layer 240 and the first barrier layer 210. The fourth barrier layer 240 may include a conductive material. For example, the fourth barrier layer 240 may include titanium (Ti), but example embodiments are not limited thereto. As another example, the fourth barrier layer 240 may include the same material as that of the second barrier layer 220, the source electrode 173, and/or the gate connection structure 170.

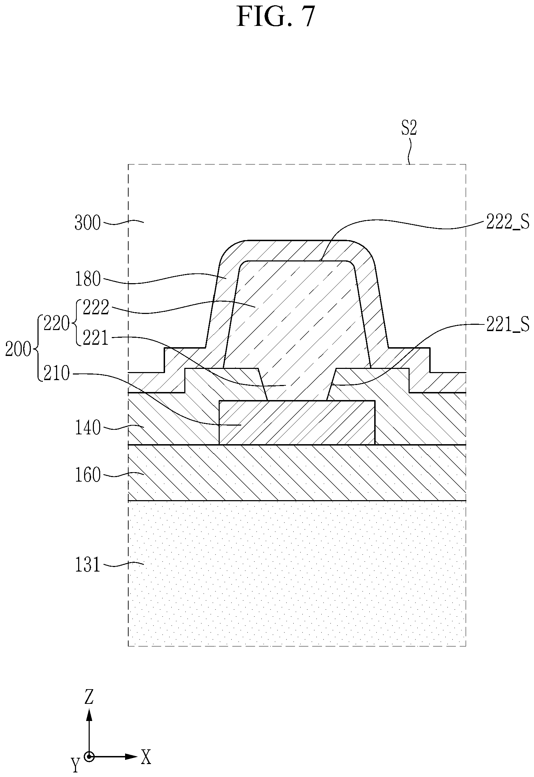

Referring to FIG. 6 and FIG. 7, the second barrier layer 220 of the semiconductor device according to some example embodiments may have various shapes.

For example, as shown in FIG 7, a side surface 221_S of the first portion 221 may include an inclined surface inclined at a desired (and/or alternatively predetermined) angle with respect to an upper surface of the substrate 110. The first portion 221 may have an inverted tapered shape on a cross-section formed in the first direction (the X direction) and the third direction (the Z direction). That is, a width of the first portion 221 along the first direction (the X direction) may increase as the first portion 221 moves away from the upper surface of the substrate 110. This may be due to a process characteristic in which at least a portion of the first interlayer insulating layer 140 is removed so that the first barrier layer 210 is exposed and the first portion 221 of the second barrier layer 220 is formed within the removed space after the first barrier layer 210 is formed and the first interlayer insulating layer 140 is formed on the first barrier layer 210.

Additionally, a side surface 222_S of the second portion 222 may include an inclined surface inclined at a desired (and/or alternatively predetermined) angle with respect to an upper surface of the substrate 110. For example, as shown in FIG. 6, the side surface 222_S of the second portion 222 may have an inverted tapered shape. That is, a width of the second portion 222 along the first direction (the X direction) may increase as the second portion 222 moves away from the upper surface of the substrate 110. As another example, as shown in FIG. 7, the side surface 222_S of the second portion 222 may have a tapered shape. That is, the width of the second portion 222 along the first direction (the X direction) may decrease as the second portion 222 moves away from the upper surface of the substrate 110. In this case, a maximum width of the second portion 222 along the first direction (the X direction) may be greater than a maximum width of the first portion 221 along the first direction (the X direction). Additionally, a minimum width of the second portion 222 along the first direction (the X direction) may be greater than a minimum width of the first portion 221 along the first direction (the X direction).

FIG. 6 and FIG. 7 show that the side surface 221_S of the first portion 221 has the inverted tapered shape, but example embodiments are not limited thereto, and the side surface 221_S of the first portion 221 may have a tapered shape.

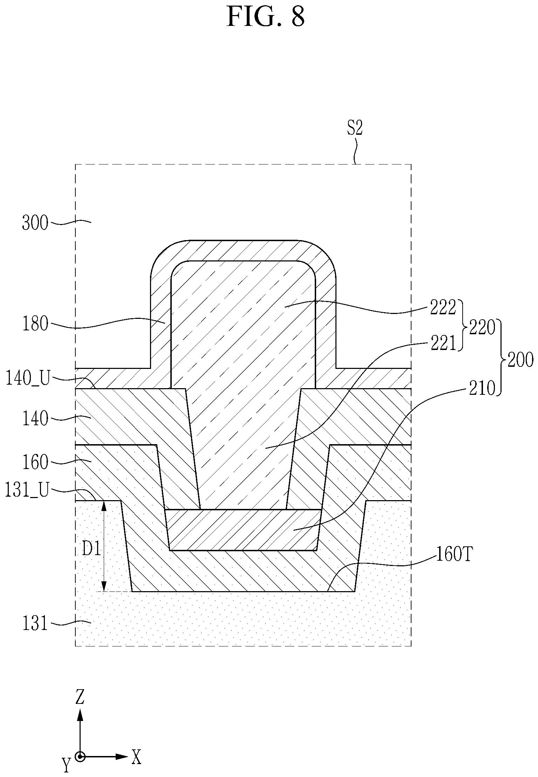

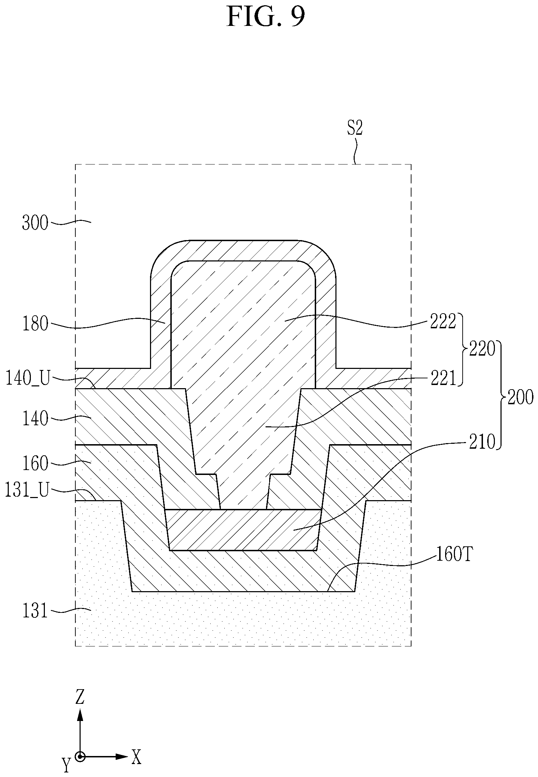

Referring to FIG. 8 and FIG. 9, the semiconductor device according to some example embodiments may further include a trench 160T disposed on an upper surface of the first conductivity type semiconductor layer 131 in the edge region.

In some example embodiments, the trench 160T may be formed to a desired (and/or alternatively predetermined) depth from the upper surface of the first conductivity type semiconductor layer 131. A side wall and a lower surface of the trench 160T may be defined by the first conductivity type semiconductor layer 131. A first depth D1 of the trench 160T along the third direction (the Z direction) may be substantially the same as a thickness of the second conductivity type doping well region 133 along the third direction (the Z direction), but example embodiments are not limited thereto. In this case, in the cell region CELL, a gate trench disposed on the upper surface of the first conductivity type semiconductor layer 131 may be further included and a trench-shaped gate structure in which the gate electrode 150 is disposed within the gate trench may be provided. Additionally, the second interlayer insulating layer 160 and the first interlayer insulating layer 140 may be disposed conformally along the lower surface and the side wall of the trench 160T.

In some example embodiments, the barrier pattern 200 may be disposed within the trench 160T. For example, the first barrier layer 210 may be buried within the trench 160T. In this case, a thickness of the first barrier layer 210 along the third direction (the Z direction) may be smaller than a depth of the trench 160T along the third direction (the Z direction). An upper surface of the first barrier layer 210 may be disposed at a lower level than that of an upper surface 131_U of the first conductivity type semiconductor layer 131.

The first portion 221 of the second barrier layer 220 may be disposed on the first barrier layer 210. The first portion 221 may extend in the third direction (the Z direction) to an upper surface 140_U of the first interlayer insulating layer 140 disposed outside the trench 160T. Accordingly, an upper surface of the first portion 221 may be disposed at substantially the same level as that of the upper surface 140_U of the first interlayer insulating layer 140 disposed outside the trench 160T. In this case, a side surface of the first portion 221 may have various shapes. For example, as shown in FIG. 8, the side surface of the first portion 221 may extend in a direction inclined at a desired (and/or alternatively predetermined) angle with respect to an upper surface of the substrate 110. As another example, as shown in FIG. 9, the side surface of the first portion 221 may include a bent portion. In a process in which the second interlayer insulating layer 160 and the first interlayer insulating layer 140 are sequentially formed and at least a portion of the first interlayer insulating layer 140 is removed to expose the first barrier layer 210, the shape may be determined according to a relationship between a width of the trench 160T along the first direction (the X direction) and a thickness of the first interlayer insulating layer 140. A lower surface of the first portion 221 may be disposed at a level lower than that of the upper surface 131_U of the first conductivity type semiconductor layer 131, but example embodiments are not limited thereto.

Referring to FIG. 10, the semiconductor device according to some example embodiments may further include a first conductivity type edge well region 138 disposed within the first conductivity type semiconductor layer 131 in the edge region EG.

The first conductivity type edge well region 138 may be disposed at an upper portion of the first conductivity type semiconductor layer 131. At least some regions of an upper surface of the first conductivity type edge well region 138 may overlap the barrier pattern 200 in the third direction (the Z direction). The upper surface of the first conductivity type edge well region 138 may be in direct contact with the barrier pattern 200. The first conductivity type edge well region 138 may not be disposed in the cell region CELL and the junction end region JTE.

In some example embodiments, the first conductivity type edge well region 138 may extend from the upper surface of the first conductivity type semiconductor layer 131 in a lower surface direction of the first conductivity type semiconductor layer 131. That is, the first conductivity type edge well region 138 may extend from the upper surface of the first conductivity type semiconductor layer 131 in the third direction (the Z direction). In this case, a second thickness D2 of the first conductivity type edge well region 138 along the third direction (the Z direction) may be substantially the same as a thickness of the second conductivity type doping well region 133 along the third direction (the Z direction). The first conductivity type edge well region 138 may be formed in at least some regions of the first conductivity type semiconductor layer 131 through an ion implantation method.

The first conductivity type edge well region 138 may be doped with an n-type impurity. A doping concentration of the first conductivity type edge well region 138 may be greater than a doping concentration of the first conductivity type semiconductor layer 131. In some example embodiments, the first conductivity type edge well region 138 may perform a function of a channel stopper that prevents expansion of a depletion layer in the edge region EG. The channel stopper may be provided at an outermost region of the semiconductor device.

The barrier pattern 200 may be disposed on the first conductivity type edge well region 138. The barrier pattern 200 may be electrically connected to the first conductivity type edge well region 138. A lower surface of the first barrier layer 210 may directly contact the first conductivity type edge well region 138, but example embodiments are not limited thereto. For example, a silicide film may be disposed between the first barrier layer 210 and the first conductivity type edge well region 138.

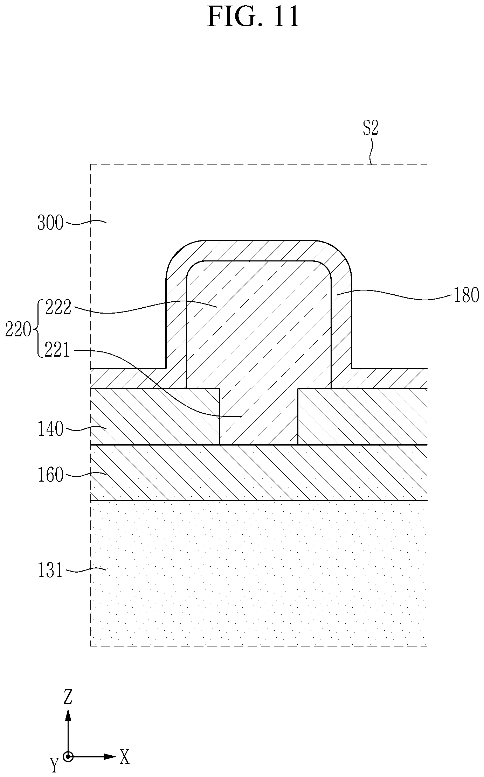

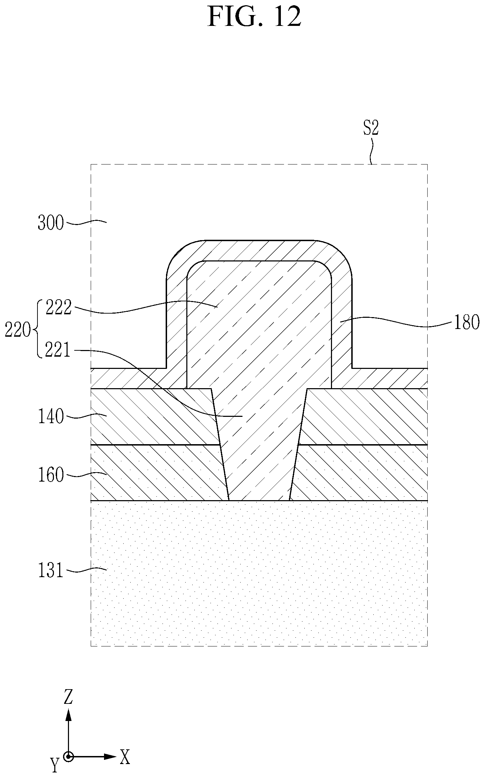

Referring to FIG. 11 and FIG. 12, the barrier pattern 200 of the semiconductor device according to some example embodiments may not include the first barrier layer 210. For example, as shown in FIG. 11, the first portion 221 of the second barrier layer 220 may be disposed on an upper surface of the second interlayer insulating layer 160. As another example, as shown in FIG. 12, the first portion 221 of the second barrier layer 220 may penetrate the second interlayer insulating layer 160 to be in contact with an upper surface of the first conductivity type semiconductor layer 131. Because the remaining description of the second barrier layer 220 is substantially the same as the description of the second barrier layer 220 of various example embodiments relating to FIGS. 1 to 4, a description thereof will be omitted.

Hereinafter, a semiconductor device according to some example embodiments will be described with reference to FIGS. 13 to 16 and 17A to 17C.

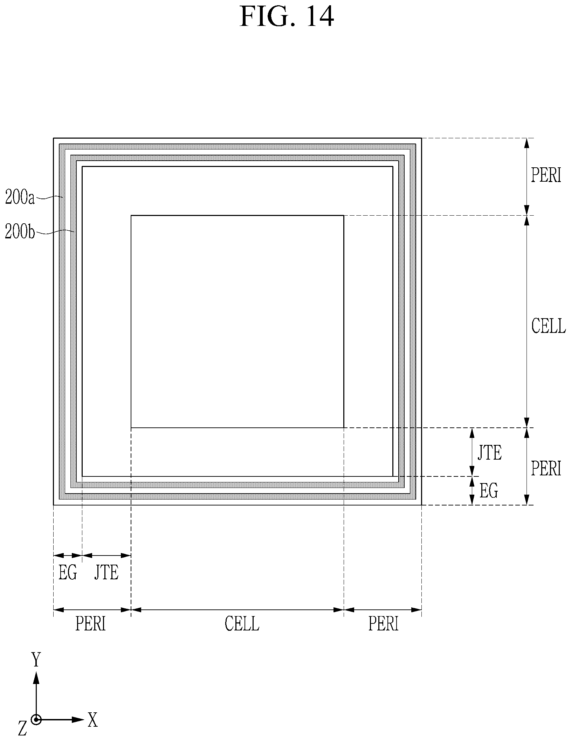

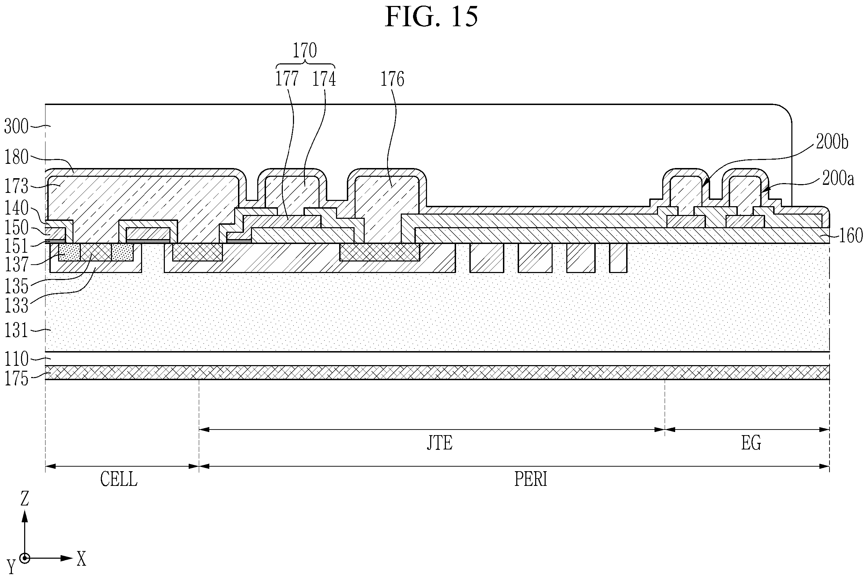

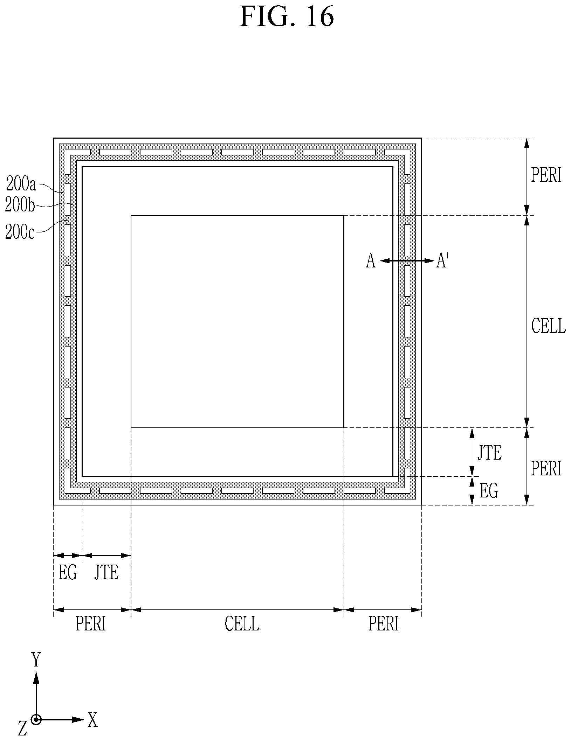

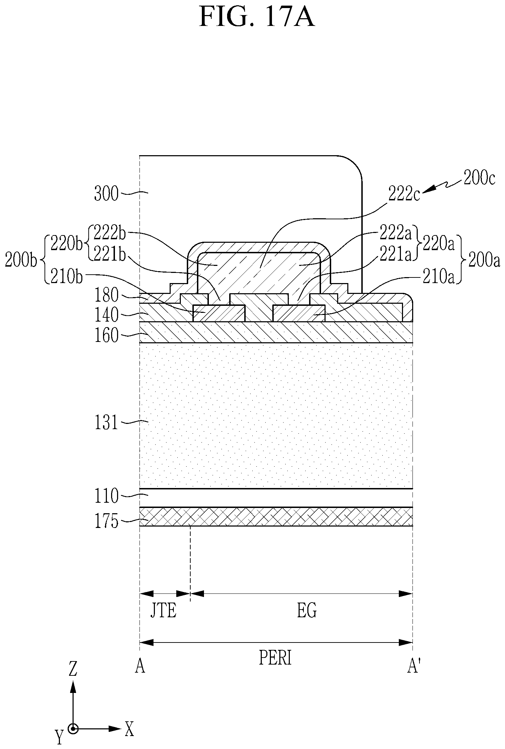

FIG. 13 and FIG. 14 are plan views showing a semiconductor device according to some example embodiments. FIG. 15 is a cross-sectional view showing the semiconductor device according to various example embodiments relating to FIG. 14. FIG. 16 is a plan view showing a semiconductor device according to some example embodiments. FIGS. 17A to 17C are cross-sectional views taken along a line A-A' of FIG. 16.

FIGS. 13 to 16 and 17A to 17C show various modified examples of the semiconductor device according to various example embodiments shown in FIGS. 1 to 4. Because various example embodiments shown in FIGS. 13 to 16 and 17A to 17C has the same portion as that of various example embodiments shown in FIGS. 1 to 4, a description thereof will be omitted and a difference between various example embodiments shown in FIGS. 13 to 16 and 17A to 17C and various example embodiments shown in FIGS. 1 to 4 will be mainly described. Additionally, the same reference numeral is used for a component that is the same as that of the previous embodiment.

Referring to FIGS. 13 to 16, the barrier pattern 200 of the semiconductor device according to some example embodiments may have various planar shapes.

Referring to FIG. 13, the barrier pattern 200 of the semiconductor device according to some example embodiments may include a plurality of barrier units (or a plurality of barrier portions) 200p. The plurality of barrier units 200p may be disposed in the edge region EG. The plurality of barrier units 200p may be disposed to surround the cell region CELL. For example, the plurality of barrier units 200p may have a desired (and/or alternatively predetermined) interval, and may surround the cell region CELL. In other words, the plurality of barrier units 200p may be disposed in the second direction (the Y direction) at both sides of the cell region CELL along the first direction (the X direction), and may be disposed in the first direction (the X direction) at both sides of the cell region CELL along the second direction (the Y direction). In some example embodiments, each of the plurality of barrier units 200p may extend in the same direction as disposition directions of the plurality of barrier units 200p, but example embodiments are not limited thereto. The plurality of barrier units 200p may protrude from an upper surface of the second interlayer insulating layer 160 in the third direction (the Z direction).

As another example, referring to FIG. 14 and FIG. 15, the barrier pattern 200 of the semiconductor device according to some example embodiments may be provided in a plural number. For example, a second barrier pattern 200b surrounding the cell region CELL and a first barrier pattern 200a surrounding the second barrier pattern 200b may be included in the edge region EG. The first barrier pattern 200a and the second barrier pattern 200b may have similar shapes. For example, the first barrier pattern 200a and the second barrier pattern 200b may have a square ring shape, but example embodiments are not limited thereto. As another example, one of a plurality of barrier patterns 200 may include a plurality of barrier units spaced apart from each other in a direction surrounding the cell region CELL as in various example embodiments relating to FIG. 13, and the other of the plurality of barrier patterns 200 may include a line-type barrier pattern extending in a direction surrounding the cell region CELL without interruption.

As another example, referring to FIGS. 16 and 17A to 17C, the semiconductor device according to some example embodiments may include the first barrier pattern 200a and the second barrier pattern 200b, and may further include a connection pattern 200c positioned between the first barrier pattern 200a and the second barrier pattern 200b. The connection pattern 200c may be disposed between the first barrier pattern 200a and the second barrier pattern 200b with a desired (and/or alternatively predetermined) interval. The connection pattern 200c may be integrated with the first barrier pattern 200a and/or the second barrier pattern 200b, but example embodiments are not limited thereto.

The connection pattern 200c may connect between the first barrier pattern 200a and the second barrier pattern 200b. For example, the connection pattern 200c may connect a first barrier layer 210a of the first barrier pattern 200a and a first barrier layer 210b of the second barrier pattern 200b and/or a second barrier layer 220a of the first barrier pattern 200a and a second barrier layer 220b of the second barrier pattern 200b.

As an example, as shown in FIG. 17a, the connection pattern 200c may include a second portion 222c disposed between a second portion 222a of the first barrier pattern 200a and a second portion 222b of the second barrier pattern 200b. The second portion 222c of the connection pattern 200c may be formed integrally with the second portion 222a of the first barrier pattern 200a and the second portion 222b of the second barrier pattern 200b, but example embodiments are not limited thereto. That is, the second portion 222a of the first barrier pattern 200a and the second portion 222b of the second barrier pattern 200b may be connected to each other to have a shape extending in the first direction (the X direction). In this case, a first portion 221a of the first barrier pattern 200a may be disposed to be spaced apart from a first portion 221b of the second barrier pattern 200b along the first direction (the X direction). The first interlayer insulating layer 140 may be disposed between the first portion 221a of the first barrier pattern 200a and the first portion 221b of the second barrier pattern 200b. Additionally, the first interlayer insulating layer 140 may be disposed between the first barrier layer 210a of the first barrier pattern 200a and the first barrier layer 210b of the second barrier pattern 200b.

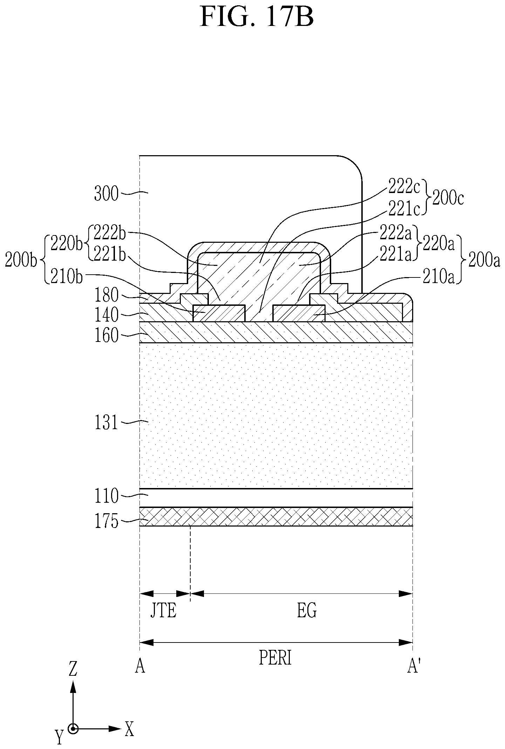

As another example, as shown in FIG. 17B, the connection pattern 200c may further include a first portion 221c disposed between the first portion 221a of the first barrier pattern 200a and the first portion 221b of the second barrier pattern 200b. The first portion 221c of the connection pattern 200c may be formed integrally with the first portion 221a of the first barrier pattern 200a and the first portion 221b of the second barrier pattern 200b, but example embodiments are not limited thereto. In this case, the first portion 221c of the connection pattern 200c may be disposed between the first barrier layer 210a of the first barrier pattern 200a and the first barrier layer 210b of the second barrier pattern 200b. The first portion 221c of the connection pattern 200c may contact an upper surface of the second interlayer insulating layer 160, but example embodiments are not limited thereto.

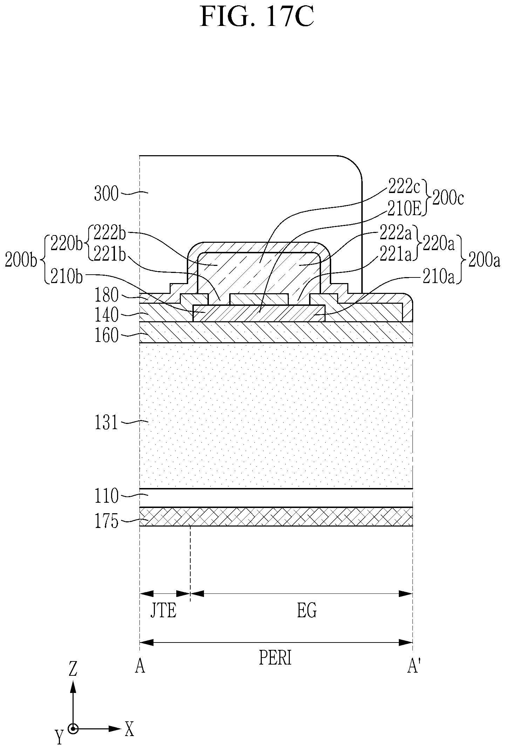

As another example, as shown in FIG. 17C, the connection pattern 200c may further include an extension portion 210E connecting the first barrier layer 210a of the first barrier pattern 200a and the first barrier layer 210b of the second barrier pattern 200b. The extension portion 210E may be formed integrally with the first barrier layer 21 0a of the first barrier pattern 200a and the first barrier layer 210b of the second barrier pattern 200b, but example embodiments are not limited thereto. Accordingly, the first barrier layer 210a of the first barrier pattern 200a and the first barrier layer 210b of the second barrier pattern 200b may be connected to each other to have a shape extending in the first direction (the X direction). In this case, the first interlayer insulating layer 140 may be disposed on the extension portion 210E. That is, the first interlayer insulating layer 140 may be disposed between the first portion 221a of the first barrier pattern 200a and the first portion 221b of the second barrier pattern 200b on the extension portion 210E.

FIGS. 17A to 17C show that at least a portion of the first barrier pattern 200a and the second barrier pattern 200b has a connected shape, but example embodiments are not limited thereto. For example, the first barrier pattern 200a, the second barrier pattern 200b, and the connection pattern 200c may be integrated. In this case, the first barrier pattern 200a, the second barrier pattern 200b, and the connection pattern 200c may be made of one pattern to have a mesh shape.

Although various example embodiments relating to FIGS. 14 to 16 shows that two barrier patterns 200 are disposed in the edge region EG, example embodiments are not limited thereto. For example, three or more barrier patterns 200 may be disposed in the edge region EG.

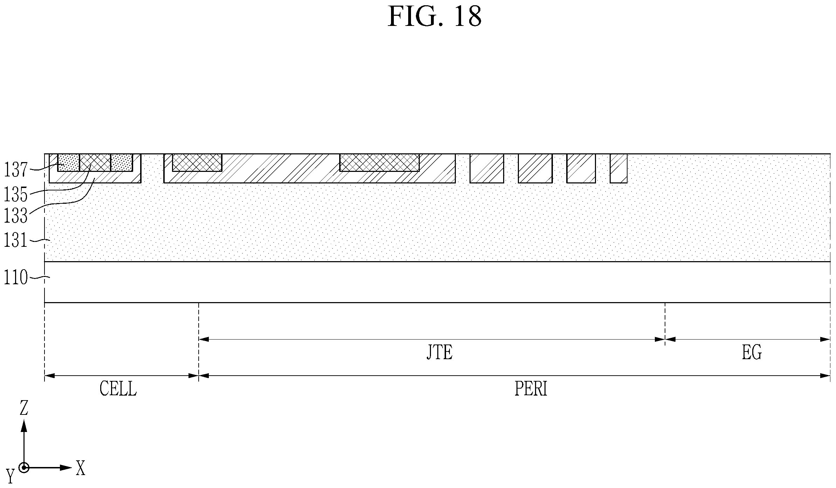

Hereinafter, a method for manufacturing the semiconductor device according to some example embodiments will be described with reference to FIGS. 18 to 26.

FIGS. 18 to 26 are process cross-sectional views sequentially showing the method for manufacturing the semiconductor device according to various example embodiments.

Referring to FIG. 18, the second conductivity type doping well region 133, the first conductivity type doping layer 137, and the second conductivity type doping layer 135 may be sequentially formed at an upper portion of the first conductivity type semiconductor layer 131 disposed on the substrate 110.

The substrate 110 may be a semiconductor substrate including SiC. For example, the substrate 110 may be formed of a 4H SiC substrate. The substrate 110 may be doped with an n-type impurity with a high concentration. The substrate 110 may include a first surface and a second surface opposite each other. The first surface of the substrate 110 may be an upper surface, and the second surface of the substrate 110 may be a lower surface.

In various example embodiments, the substrate 110 may include the cell region CELL and the peripheral circuit region PERI surrounding the cell region CELL. Additionally, the peripheral circuit region PERI may include the junction end region JTE surrounding the cell region CELL and the edge region EG surrounding the junction end region JTE.

The first conductivity type semiconductor layer 131 may be formed on the first surface (that is, the upper surface) of the substrate 110 using an epitaxial growth method. The first conductivity type semiconductor layer 131 may be formed directly on the substrate 110, or another desired (and/or alternatively predetermined) layer may be formed on the substrate 110, and then the first conductivity type semiconductor layer 131 may be formed on the other layer. The first conductivity type semiconductor layer 131 may include SiC. For example, the first conductivity type semiconductor layer 131 may include 4H SiC. The first conductivity type semiconductor layer 131 may be doped with an n-type impurity with a low concentration. A doping type of the first conductivity type semiconductor layer 131 may be the same as a doping type of the substrate 110. A doping material of the first conductivity type semiconductor layer 131 may be the same as or different from a doping material of the substrate 110. A doping concentration of the first conductivity type semiconductor layer 131 may be lower than a doping concentration of the substrate 110.

Next, in the cell region CELL and the junction end region JTE, the second conductivity type doping well region 133 may be formed at an upper region of the first conductivity type semiconductor layer 131. The second conductivity type doping well region 133 may be formed by an ion implantation process (IIP). First, a region in which the second conductivity type doping well region 133 is formed may be defined on the first conductivity type semiconductor layer 131 using a photolithography process. Thereafter, second conductivity type impurity ions may be implanted in the region. The second conductivity type doping well region 133 may have a desired (and/or alternatively predetermined) depth. In this case, the depth of the second conductivity type doping well region 133 may be determined by the number of ions implanted and/or a speed at which the ions are accelerated.

In various example embodiments, the second conductivity type doping well region 133 may include SiC. For example, the second conductivity type doping well region 133 may include 4H SiC. The second conductivity type doping well region 133 may be doped with a p-type impurity. The second conductivity type doping well region 133 may be doped with the p-type impurity with a low concentration. For example, a doping concentration of the second conductivity type doping well region 133 may be about 1*1017 cm-3 or more and about 1*1019 cm-3 or less. A material, a doping type, a doping concentration, and the like of the second conductivity type doping well region 133 are not limited thereto, and may be variously changed.

Next, ions may be implanted into the second conductivity type doping well region 133 to form the first conductivity type doping layer 137. The first conductivity type doping layer 137 may be formed within the second conductivity type doping well region 133 through an ion implantation process. The first conductivity type doping layer 137 may be formed in at least some regions of the second conductivity type doping well region 133. For example, the first conductivity type doping layer 137 may be formed to a desired (and/or alternatively predetermined) depth from an upper surface of the second conductivity type doping well region 133.

The first conductivity type doping layer 137 may include SiC. For example, the first conductivity type doping layer 137 may include 4H SiC. The first conductivity type doping layer 137 may be doped with an n-type impurity with a high concentration. A doping type of the first conductivity type doping layer 137 may be different from a doping type of the second conductivity type doping well region 133. The doping type of the first conductivity type doping layer 137 may be the same as doping types of the substrate 110 and the first conductivity type semiconductor layer 131. A doping concentration of the first conductivity type doping layer 137 may be about 1*1018 cm-3 or more and about 5*1020 cm-3 or less. A material, a doping type, a doping concentration, and the like of the first conductivity type doping layer 137 are not limited thereto, and may be variously changed.

Next, the second conductivity type doping layer 135 may be further formed by implanting ions into the second conductivity type doping well region 133 and the first conductivity type doping layer 137. First, a region in which the second conductivity type doping layer 135 is formed on the first conductivity type doping layer 137 may be defined using a photolithography process. The region where the second conductivity type doping layer 135 is formed may have a smaller width than that of the second conductivity type doping well region 133 or the first conductivity type doping layer 137. In various example embodiments, a depth at which the second conductivity type doping layer 135 is formed may be deeper than a depth of the first conductivity type doping layer 137. The second conductivity type doping layer 135 may penetrate the first conductivity type doping layer 137 in a vertical direction. At least some regions of both side surfaces of the second conductivity type doping layer 135 may be surrounded by the first conductivity type doping layer 137.

The second conductivity type doping layer 135 may include SiC. For example, the second conductivity type doping layer 135 may include 4H SiC. The second conductivity type doping layer 135 may be doped with a p-type impurity with a high concentration. A doping type of the second conductivity type doping layer 135 may be the same as a doping type of the second conductivity type doping well region 133. A doping material of the second conductivity type doping layer 135 may be the same as or different from a doping material of the second conductivity type doping well region 133. The doping concentration of the second conductivity type doping layer 135 may be higher than the doping concentration of the second conductivity type doping well region 133.

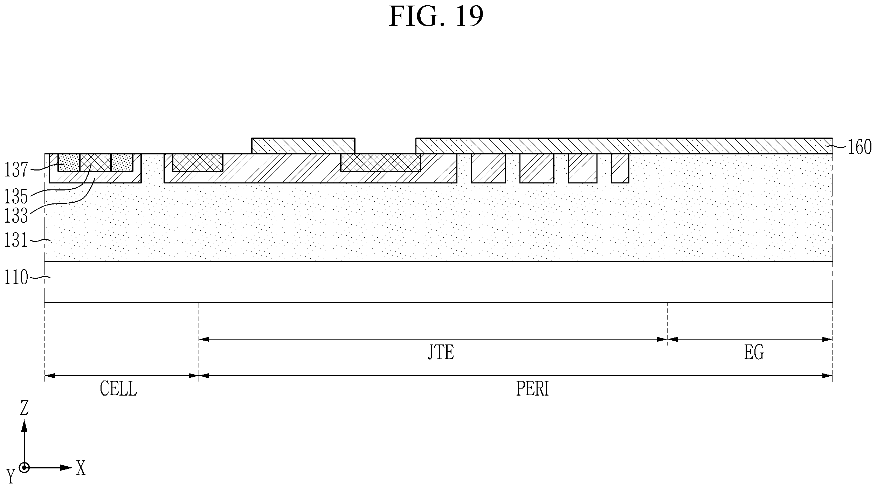

Referring to FIG. 19, in the junction end region JTE and the edge region EG, the second interlayer insulating layer 160 may be formed on the first conductivity type semiconductor layer 131. Specifically, in the junction end region JTE, the second interlayer insulating layer 160 may cover at least a portion of the second conductivity type doping well region 133 and may expose at least a portion of the second conductivity type doping layer 135. An upper surface of the exposed second conductivity type doping layer 135 may be a space where the contact electrode 176 is formed in a later process. Additionally, in the edge region EG, the second interlayer insulating layer 160 may completely cover the first conductivity type semiconductor layer 131. Additionally, the second interlayer insulating layer 160 may not be formed in the cell region CELL. Accordingly, in the cell region CELL, upper surfaces of the second conductivity type doping layer 135, the first conductivity type doping layer 137, the second conductivity type doping well region 133, and the first conductivity type semiconductor layer 131 may be exposed.

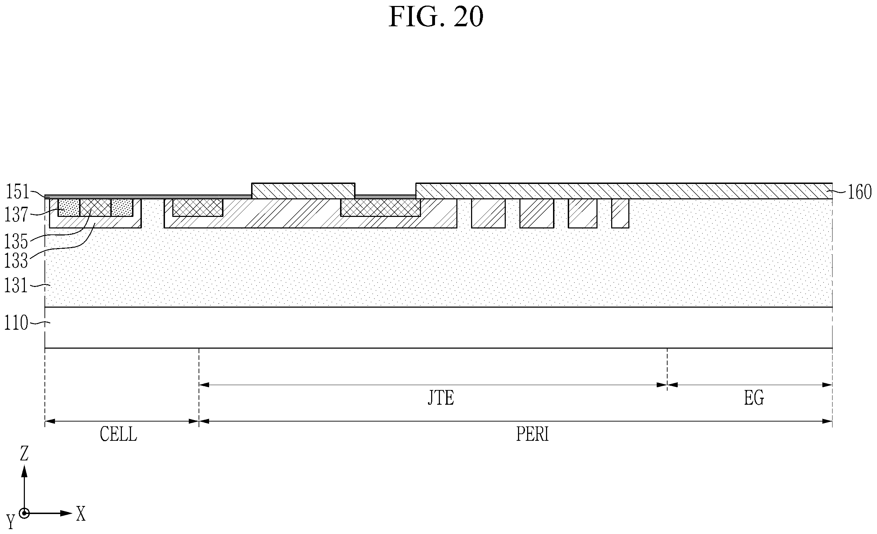

Referring to FIG. 20, the gate insulating layer 151 may be formed on the second conductivity type doping layer 135, the first conductivity type doping layer 137, the second conductivity type doping well region 133, and the first conductivity type semiconductor layer 131 that are exposed. The gate insulating material layer may be formed on entire upper surfaces of the first conductivity type semiconductor layer 131, the second conductivity type doping well region 133, the first conductivity type doping layer 137, and the second conductivity type doping layer 135 that are exposed. The gate insulating material layer may be formed by a high temperature oxidation process.

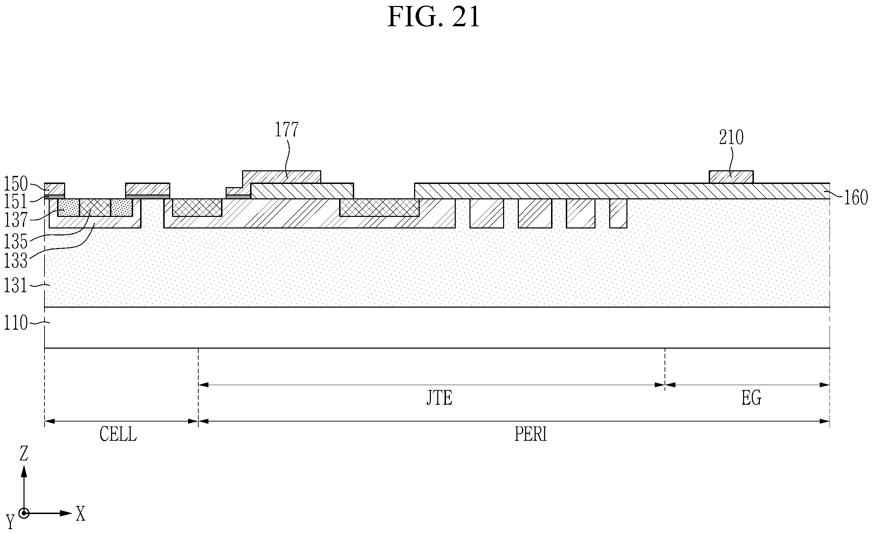

Referring to FIG. 21, the gate electrode 150 may be formed on the gate insulating layer 151 in the cell region CELL, the first gate connection wire 177 may be formed in the junction termination region JTE, and the first barrier layer 210 may be formed on the second interlayer insulating layer 160 in the edge region EG.

Specifically, a gate material layer may be formed by depositing a conductive material (e.g., polysilicon) on the gate insulating layer 151 and the second interlayer insulating layer 160. The gate material layer may be entirely disposed in the cell region CELL, the junction end region JTE, and the edge region EG. Thereafter, the gate insulating layer 151 and the gate material layer may be patterned to form the gate electrode 150, the first gate connection wire 177, and the first barrier layer 210 together. In this case, the gate electrode 150, the first gate connection wire 177, and the first barrier layer 210 may include the same material. In the cell region CELL, an upper surface of the second conductivity type doping layer 135 and a portion of an upper surface of the first conductivity type doping layer 137 may be exposed.

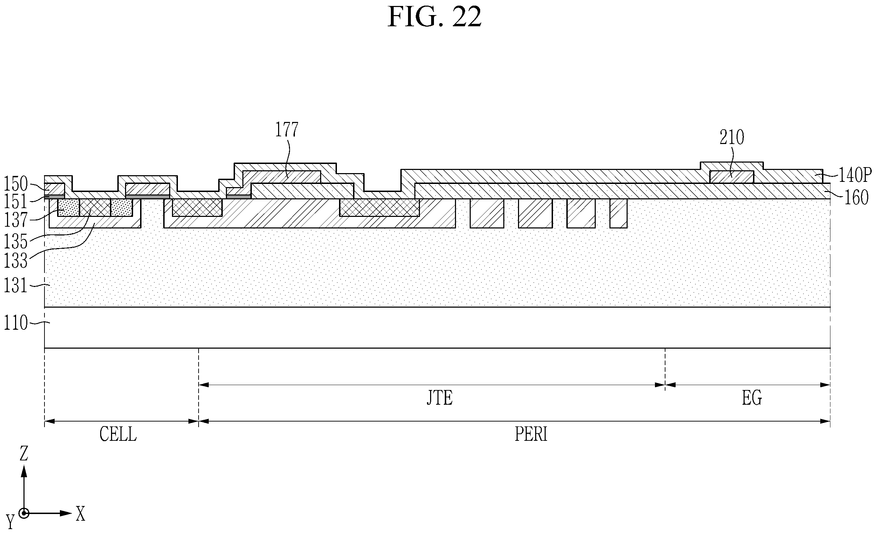

Referring to FIG. 22, a first preliminary interlayer insulating layer 140P may be formed on the gate electrode 150, the first gate connection wire 177, the first barrier layer 210, and the second interlayer insulating layer 160. The first preliminary interlayer insulating layer 140P may be entirely disposed in the cell region CELL, the junction end region JTE, and the edge region EG. The first preliminary interlayer insulating layer 140P may cover upper and side surfaces of the gate electrode 150, the first gate connection wire 177, and the first barrier layer 210. In this case, the first preliminary interlayer insulating layer 140P may also be formed on the upper surface of the second conductivity type doping layer 135 and the portion of the upper surface of the first conductivity type doping layer 137 that are exposed. The first preliminary interlayer insulating layer 140P may cover the upper surface of the second conductivity type doping layer 135 and the portion of the upper surface of the first conductivity type doping layer 137 that are exposed. In various example embodiments, the first preliminary interlayer insulating layer 140P may be formed by chemical vapor deposition. However, example embodiments are not limited thereto, and the first preliminary interlayer insulating layer 140P may be formed by various deposition methods.

Referring to FIG. 23, the first trench TR1 and a second trench TR2 may be formed by patterning the first preliminary interlayer insulating layer 140P.

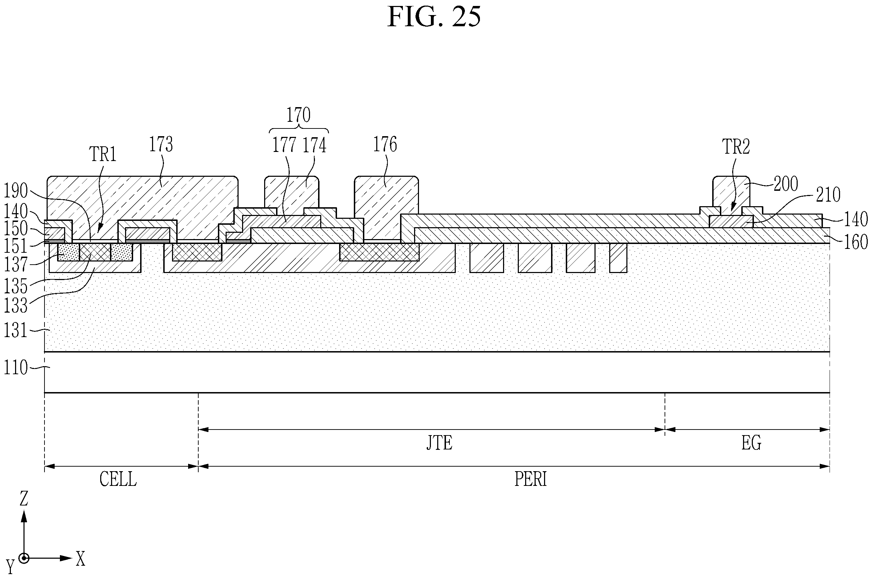

The first trench TR1 exposing the upper surface of the second conductivity type doping layer 135 and the portion of the upper surface of the first conductivity type doping layer 137 may be formed in the cell region CELL, and the second trench TR2 exposing a portion of an upper surface of the first barrier layer 210 may be formed in the edge region EG. Here, the first trench TR1 may be a space where the source electrode 173 of FIG. 25 is formed in a later process, and the second trench TR2 may be a space where the second barrier layer 220 of FIG. 25 is formed in a later process. The trenches TR1 and TR2 may be formed by a photolithography process.

In this case, a third trench exposing at least a portion of the upper surface of the second conductivity type doping layer 135 and a fourth trench exposing at least a portion of an upper surface of the first gate connection wire 177 may be formed together in the junction end region JTE. The third trench may be a space where the contact electrode 176 of FIG. 25 is formed in a later process, and the fourth trench may be a space where the second gate connection wire 174 of FIG. 25 is formed in a later process.

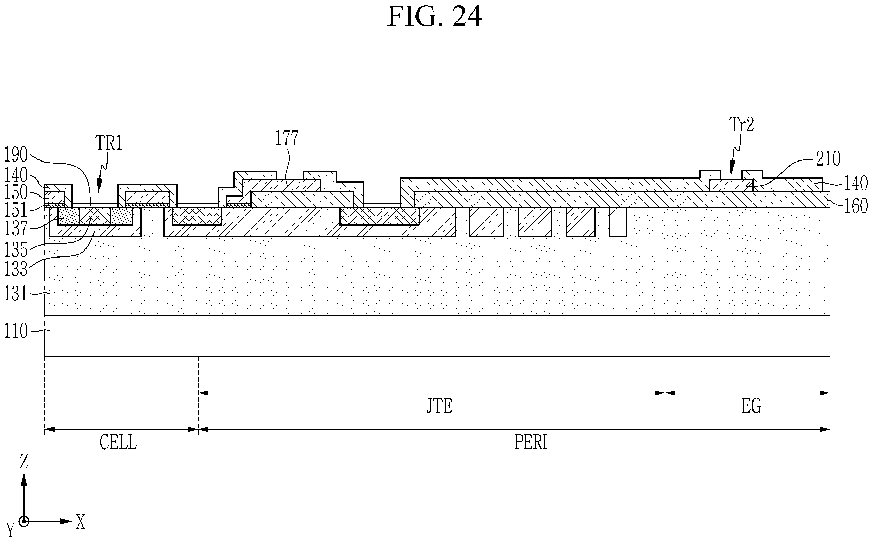

Referring to FIG. 24, the silicide layer 190 may be formed on the upper surface of the second conductivity type doping layer 135 exposed by the first trench TR1. The silicide layer 190 may include a metal silicide material. For example, the silicide layer 190 may include tungsten silicide (WSi), titanium silicide (TiSi), cobalt silicide (CoSi), nickel silicide (NiSi), or a combination thereof. However, example embodiments are not limited thereto.

In this case, as in various example embodiments relating to FIG. 5, a silicide material layer may be additionally formed on an upper surface of the first barrier layer 210 exposed by the second trench TR2, but example embodiments are not limited thereto. In addition, a silicide material layer may be formed on the upper surface of the second conductivity type doping layer 135 exposed by the third trench and the upper surface of the first gate connection wire 177 exposed by the fourth trench, but example embodiments are not limited thereto.

Referring to FIG. 25, the source electrode 173 may be formed within the first trench TR1 in the cell region CELL, and the second barrier layer 220 may be formed within the second trench TR2 in the edge region EG.

In a process of forming the source electrode 173 and the second barrier layer 220, a conductive material may be entirely deposited in the cell region CELL, the junction end region JTE, and the edge region EG, and then the conductive material may be patterned. That is, the source electrode 173 and the second barrier layer 220 may be simultaneously formed in the same process. The source electrode 173 may be formed above portions of an upper surface of the second conductivity type doping layer 135 and an upper surface of the first conductivity type doping layer 137 in the cell region CELL. The second barrier layer 220 may be formed on an upper surface of the first barrier layer 210 exposed by the second trench TR2 and a portion of an upper surface of the first interlayer insulating layer 140 in the edge region EG. The second barrier layer 220 may penetrate at least a portion of the first interlayer insulating layer 140. Accordingly, the barrier pattern 200 of the semiconductor device according to various example embodiments may be formed. In this case, in the junction end region JTE, the second gate connection wire 174 may be formed on the first gate connection wire 177 and the contact electrode 176 may be formed above the second conductivity type doping layer 135.

In various example embodiments, the second barrier layer 220 may include the same material as that of the source electrode 173 and/or that of the second gate connection wire 174. For example, the source electrode 173 may include a metal, a metal alloy, conductive metal nitride, metal silicide, a doped semiconductor material, conductive metal oxide, conductive metal oxynitride, or the like. However, example embodiments are not limited thereto.

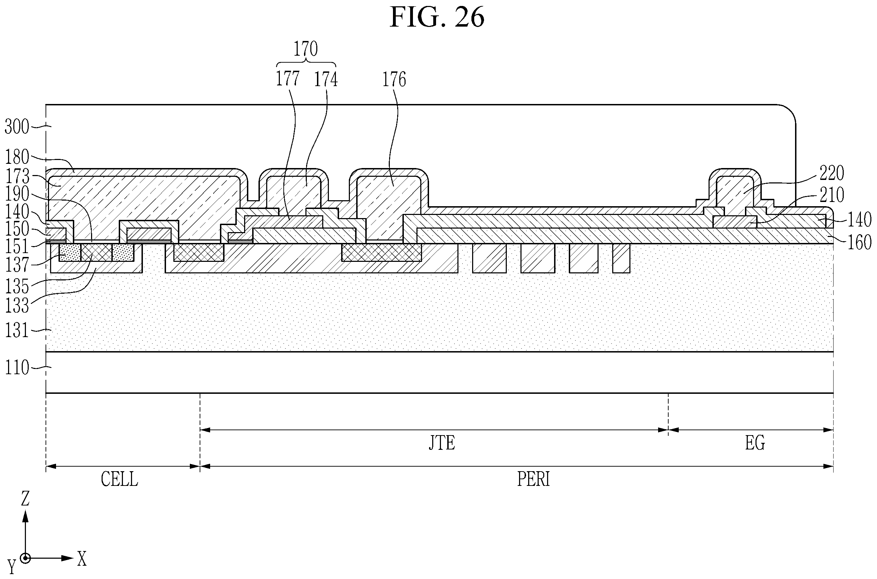

Referring to FIG. 26, the upper insulating layer 180 covering the source electrode 173 and the barrier pattern 200 may be formed, and the capping layer 300 may be formed on the upper insulating layer 180.

First, the upper insulating layer 180 may be formed to entirely cover the cell region CELL, the junction end region JTE, and the edge region EG. That is, the upper insulating layer 180 may cover the source electrode 173, the gate connection structure 170, the contact electrode 176, the barrier pattern 200, and the first interlayer insulating layer 140. The upper insulating layer 180 may be conformally disposed on the source electrode 173, the gate connection structure 170, the contact electrode 176, and the barrier pattern 200. Specifically, because the barrier pattern 200 protrudes from the second interlayer insulating layer 160 in the third direction (the Z direction), an upper surface of the upper insulating layer 180 may include a portion protruding from the second interlayer insulating layer 160 in the third direction (the Z direction) in the edge region EG. The upper insulating layer 180 may include an insulating material.

Subsequently, the capping layer 300 may be formed on the upper insulating layer 180. The capping layer 300 may be entirely formed in the cell region CELL, the junction end region JTE, and the edge region EG. The capping layer 300 may be disposed on the upper insulating layer 180 in the cell region CELL, the junction end region JTE, and the edge region EG. The capping layer 300 may entirely cover the upper insulating layer 180, but the capping layer 300 may include a portion that does not cover the upper insulating layer 180 at an end of the edge region EG. The capping layer 300 may be a layer that prevents doped regions, conductive electrodes, or the like of the semiconductor device according to various example embodiments from being exposed to oxygen or moisture.

Referring further to FIGS. 1 to 4, the drain electrode 175 may be formed on the second surface of the substrate 110 to form the semiconductor device according to various example embodiments.

The drain electrode 175 may cover an entire second side surface of the substrate 110. However, example embodiments are not limited thereto, and the drain electrode 175 may only cover a portion of the second surface of the substrate 110. The drain electrode 175 may include a conductive material. For example, the drain electrode 175 may include a metal, a metal alloy, conductive metal nitride, metal silicide, a doped semiconductor material, conductive metal oxide, conductive metal oxynitride, or the like. However, example embodiments are not limited thereto. The drain electrode 175 may be made of the same material as that of the source electrode 173, or may be made of a material different from that of the source electrode 173. The drain electrode 175 may be made of a single layer or multiple layers.

Embodiments are set out in the following clauses:
Clause 1. A semiconductor device comprising: a substrate including a cell region and a peripheral circuit region outside the cell region; a first conductivity type semiconductor layer on a first surface of the substrate; a second conductivity type doping well region within the first conductivity type semiconductor layer; a gate electrode above the first conductivity type semiconductor layer in the cell region; a gate insulating layer between the first conductivity type semiconductor layer and the gate electrode; a source electrode above the second conductivity type doping well region; a drain electrode on a second surface of the substrate, the second surface being opposite the first surface; a barrier pattern including a first barrier layer above the first conductivity type semiconductor layer, and a second barrier layer on the first barrier layer in the peripheral circuit region; and a first interlayer insulating layer covering an upper surface and a side surface of the gate electrode, and the first interlayer insulating layer is between the first barrier layer and the second barrier layer, wherein the second barrier layer penetrates at least a portion of the first interlayer insulating layer to be connected to the first barrier layer.
Clause 2. The semiconductor device of clause 1, wherein a material of the first barrier layer is the same as a material of the gate electrode, and a material of the second barrier layer is the same as a material of the source electrode.
Clause 3. The semiconductor device of clause 1 or 2, wherein the second barrier layer includes a first portion penetrating at least a portion of the first interlayer insulating layer, a second portion on the first portion, and at least a portion of the second portion overlapping the first interlayer insulating layer in a vertical direction, the vertical direction being perpendicular to an upper surface of the substrate.
Clause 4. The semiconductor device of clause 3, wherein a width of the first portion along a first direction is less than a width of the second portion along the first direction.
Clause 5. The semiconductor device of clause 3 or 4, wherein a width of the first portion along a first direction increases as a distance from an upper surface of the substrate increases.
Clause 6. The semiconductor device of any preceding clause, wherein a distance from an upper surface of the second barrier layer to an upper surface of the substrate is the same as a distance from an upper surface of the source electrode to an upper surface of the substrate.
Clause 7. The semiconductor device of any preceding clause, further comprising a second interlayer insulating layer is between the first conductivity type semiconductor layer and the first barrier layer, and the second interlayer insulating layer is on the second conductivity type doping well region in the peripheral circuit region.
Clause 8. The semiconductor device of clause 7, wherein the second interlayer insulating layer does not overlap the second conductivity type doping well region in a vertical direction of the substrate in the cell region.
Clause 9. The semiconductor device of any preceding clause, wherein the first interlayer insulating layer covers at least a portion of an upper surface of the first barrier layer.
Clause 10. The semiconductor device of any preceding clause, wherein the barrier pattern further includes a third barrier layer between the first barrier layer and the second barrier layer.
Clause 11. The semiconductor device of any preceding clause, further comprising a trench on an upper surface of the first conductivity type semiconductor layer, wherein the barrier pattern is within the trench.
Clause 12. The semiconductor device of any preceding clause, further comprising a first conductivity type edge well region within the first conductivity type semiconductor layer, wherein the barrier pattern is in contact with the first conductivity type edge well region.
Clause 13. The semiconductor device of clause 12, wherein a thickness of the first conductivity type edge well region is equal to a thickness of the second conductivity type doping well region.
Clause 14. The semiconductor device of any preceding clause, further comprising a capping layer covering the source electrode and the barrier pattern.
Clause 15. A semiconductor device comprising: a substrate including a cell region and an edge region surrounding the cell region; a first conductivity type semiconductor layer on a first surface of the substrate; a gate electrode above the first conductivity type semiconductor layer in the cell region; a second conductivity type doping well region within the first conductivity type semiconductor layer in the cell region; a first interlayer insulating layer covering an upper surface and a side surface of the gate electrode; a source electrode above the second conductivity type doping well region in the cell region; a drain electrode on a second surface facing the first surface of the substrate; and a barrier pattern including a first barrier layer above the first conductivity type semiconductor layer, the first barrier layer including a material the same as a material of the gate electrode, a second barrier layer on the first barrier layer, and the second barrier layer penetrating at least a portion of the first interlayer insulating layer in the edge region.
Clause 16. The semiconductor device of clause 15, wherein the first interlayer insulating layer covers an upper surface of the first barrier layer.
Clause 17. The semiconductor device of clause 15 or 16, wherein the substrate further includes a junction end region between the cell region and the edge region, and the second conductivity type doping well region is within the first conductivity type semiconductor layer in the junction end region.
Clause 18. The semiconductor device of clause 17, further comprising a second interlayer insulating layer between the first conductivity type semiconductor layer and the first barrier layer in the junction end region and the edge region.
Clause 19. A semiconductor device comprising: a substrate; a first conductivity type semiconductor layer on a first surface of the substrate; a second conductivity type doping well region within the first conductivity type semiconductor layer; a gate electrode above the first conductivity type semiconductor layer; a first interlayer insulating layer covering an upper surface and a side surface of the gate electrode; a barrier pattern at one side of the gate electrode above the first conductivity type semiconductor layer; a source electrode above the second conductivity type doping well region; a drain electrode on a second surface of the substrate, the second surface being opposite the first surface; and a capping layer covering the source electrode, the barrier pattern, and the first interlayer insulating layer, wherein the barrier pattern comprises a first barrier layer above the first conductivity type semiconductor layer, the first barrier layer including a material the same as a material of the gate electrode, a second barrier layer on the first barrier layer, the second barrier layer penetrating at least a portion of the first interlayer insulating layer, and the second barrier layer including a material the same as a material of the source electrode.
Clause 20. The semiconductor device of clause 19, wherein the first barrier layer includes polysilicon and the second barrier layer includes a conductive material.

While this disclosure has been described in connection with what is presently considered to be practical example embodiments, it is to be understood that the disclosure is not limited to the disclosed example embodiments, but, on the contrary, is intended to cover various modifications and equivalent arrangements included within the scope of the appended claims.

## Claims

1. A semiconductor device comprising:
a substrate including a cell region and a peripheral circuit region outside the cell region;
a first conductivity type semiconductor layer on a first surface of the substrate;
a second conductivity type doping well region within the first conductivity type semiconductor layer;
a gate electrode above the first conductivity type semiconductor layer in the cell region;
a gate insulating layer between the first conductivity type semiconductor layer and the gate electrode;
a source electrode above the second conductivity type doping well region;
a drain electrode on a second surface of the substrate, the second surface being opposite the first surface;
a barrier pattern including
a first barrier layer above the first conductivity type semiconductor layer, and
a second barrier layer on the first barrier layer in the peripheral circuit region; and
a first interlayer insulating layer covering an upper surface and a side surface of the gate electrode, and
the first interlayer insulating layer is between the first barrier layer and the second barrier layer,
wherein the second barrier layer penetrates at least a portion of the first interlayer insulating layer to be connected to the first barrier layer.

2. The semiconductor device of claim 1,
wherein a material of the first barrier layer is the same as a material of the gate electrode, and
a material of the second barrier layer is the same as a material of the source electrode.

3. The semiconductor device of claim 1 or 2,
wherein the second barrier layer includes
a first portion penetrating at least a portion of the first interlayer insulating layer,
a second portion on the first portion, and
at least a portion of the second portion overlapping the first interlayer insulating layer in a vertical direction, the vertical direction being perpendicular to an upper surface of the substrate.

4. The semiconductor device of claim 3,
wherein a width of the first portion along a first direction is less than a width of the second portion along the first direction.

5. The semiconductor device of claim 3 or 4,
wherein a width of the first portion along a first direction increases as a distance from an upper surface of the substrate increases.

6. The semiconductor device of any preceding claim,
wherein a distance from an upper surface of the second barrier layer to an upper surface of the substrate is the same as a distance from an upper surface of the source electrode to an upper surface of the substrate.

7. The semiconductor device of any preceding claim, further comprising
a second interlayer insulating layer between the first conductivity type semiconductor layer and the first barrier layer, and
the second interlayer insulating layer is on the second conductivity type doping well region in the peripheral circuit region.

8. The semiconductor device of claim 7,
wherein the second interlayer insulating layer does not overlap the second conductivity type doping well region in a vertical direction of the substrate in the cell region.

9. The semiconductor device of any preceding claim,
wherein the first interlayer insulating layer covers at least a portion of an upper surface of the first barrier layer.

10. The semiconductor device of any preceding claim,
wherein the barrier pattern further includes a third barrier layer between the first barrier layer and the second barrier layer.

11. The semiconductor device of any preceding claim, further comprising
a trench on an upper surface of the first conductivity type semiconductor layer,
wherein the barrier pattern is within the trench.

12. The semiconductor device of any preceding claim, further comprising
a first conductivity type edge well region within the first conductivity type semiconductor layer,
wherein the barrier pattern is in contact with the first conductivity type edge well region.

13. The semiconductor device of claim 12,
wherein a thickness of the first conductivity type edge well region is equal to a thickness of the second conductivity type doping well region.

14. The semiconductor device of any preceding claim, further comprising
a capping layer covering the source electrode and the barrier pattern.

15. The semiconductor device of claim 13 or 14,
the first conductivity type edge well region is doped with an n-type impurity, and
the first conductivity type semiconductor layer is doped with an p-type impurity,
wherein a doping concentration of the first conductivity type edge well region is greater than a doping concentration of the first conductivity type semiconductor layer.

## Amended claims

### Amended claims in accordance with Rule 137(2) EPC.

1. A semiconductor device comprising:
a substrate (110) including a cell region (CELL) and a peripheral circuit region (PERI) outside the cell region, wherein the peripheral circuit region includes a junction end region (JTE) surrounding the cell region and an edge region (EG) surrounding the junction end region (JTE);
a first conductivity type semiconductor layer (131) on a first surface of the substrate;
a second conductivity type doping well region (133) within the first conductivity type semiconductor layer in the cell region and the junction end region;
a gate electrode (150) above the first conductivity type semiconductor layer in the cell region;
a gate insulating layer (151) between the first conductivity type semiconductor layer and the gate electrode;
a source electrode (173) above the second conductivity type doping well region;
a drain electrode (175) on a second surface of the substrate, the second surface being opposite the first surface;
a barrier pattern (200) disposed at the edge region and including
a first barrier layer (210) above the first conductivity type semiconductor layer, and
a second barrier layer (220) on the first barrier layer in the peripheral circuit region;
an upper insulating layer (180) conformally covering the source electrode and the barrier pattern,
a capping layer (300) covering the upper insulating layer (180),
a first interlayer insulating layer (140) covering an upper surface and a side surface of the gate electrode, and
the first interlayer insulating layer is between the first barrier layer and the second barrier layer,
wherein the second barrier layer penetrates at least a portion of the first interlayer insulating layer to be connected to the first barrier layer.

2. The semiconductor device of claim 1,
wherein a material of the first barrier layer (210) is the same as a material of the gate electrode (150), and
a material of the second barrier layer (220) is the same as a material of the source electrode (173).

3. The semiconductor device of claim 1 or 2,
wherein the second barrier layer (220) includes
a first portion (221) penetrating at least a portion of the first interlayer insulating layer (140),
a second portion (222) on the first portion, and
at least a portion of the second portion overlapping the first interlayer insulating layer in a vertical direction, the vertical direction being perpendicular to an upper surface of the substrate (110).

4. The semiconductor device of claim 3,
wherein a width of the first portion (221) along a first direction is less than a width of the second portion along the first direction, the first direction being a horizontal direction parallel to the upper surface of the substrate.

5. The semiconductor device of claim 3 or 4,
wherein a width of the first portion (221) along the first direction increases as a distance from an upper surface of the substrate (110) increases.

6. The semiconductor device of any preceding claim,
wherein a distance from an upper surface of the second barrier layer (220) to an upper surface of the substrate (110) is the same as a distance from an upper surface of the source electrode (173) to an upper surface of the substrate.

7. The semiconductor device of any preceding claim, further comprising
a second interlayer insulating layer (160) between the first conductivity type semiconductor layer (131) and the first barrier layer (210), and
the second interlayer insulating layer is on the second conductivity type doping well region (133) in the peripheral circuit region (PERI).

8. The semiconductor device of claim 7,
wherein the second interlayer insulating layer (160) does not overlap the second conductivity type doping well region (133) in a vertical direction of the substrate (110) in the cell region (CELL).

9. The semiconductor device of any preceding claim,
wherein the first interlayer insulating layer (140) covers at least a portion of an upper surface of the first barrier layer (210).

10. The semiconductor device of any preceding claim,
wherein the barrier pattern further includes a third barrier layer (230) between the first barrier layer (210) and the second barrier layer (220).

11. The semiconductor device of any preceding claim, further comprising
a trench (160T) on an upper surface of the first conductivity type semiconductor layer (131),
wherein the barrier pattern (200) is within the trench.

12. The semiconductor device of any preceding claim, further comprising
a first conductivity type edge well region (138) within the first conductivity type semiconductor layer (131),
wherein the barrier pattern (200) is in contact with the first conductivity type edge well region.

13. The semiconductor device of claim 12,
wherein a thickness of the first conductivity type edge well region (138) is equal to a thickness of the second conductivity type doping well region (133).

14. The semiconductor device of claim 13,
the first conductivity type edge well region (138) is doped with an n-type impurity, and
the first conductivity type semiconductor layer (131) is doped with an n-type impurity,
wherein a doping concentration of the first conductivity type edge well region is greater than a doping concentration of the first conductivity type semiconductor layer.
